# EUROPEAN PATENT SPECIFICATION

(11) **EP 0 661 760 B1**
(45) Date of publication and mention of the grant of the patent: **11.04.2007**
(21) Application number: 94309853.3
(22) Date of filing: 28.12.1994
(51) Int. Cl.: H01L 31/20, H01L 31/075, H01L 21/205, H01L 31/0392, C23C 16/50, C23C 16/54

(54) **Method and apparatus for forming deposited film**
Verfahren und Vorrichtung zur Bildung eines abgeschiedenen Films
Méthode et appareil pour former des couches déposées

(30) Priority: 28.12.1993 JP 33746793; 22.12.1994 JP 32003494
(43) Date of publication of application: 05.07.1995
(73) Proprietor: CANON KABUSHIKI KAISHA, Tokyo (JP)
(72) Inventor: Matsuda, Koichi, c/o Canon Kabushiki Kaisha, Tokyo (JP); Kondo, Takaharu, c/o Canon Kabushiki Kaisha, Tokyo (JP); Miyamoto, Yusuke, c/o Canon Kabushiki Kaisha, Tokyo (JP)
(74) Representative: Beresford, Keith Denis Lewis

(56) References cited:
- EP-A- 0 406 690
- US-A- 4 951 602
- US-A- 5 258 075
- PATENT ABSTRACTS OF JAPAN vol. 9 no. 69 (E-305) [1792] ,29 March 1985 & JP-A-59 208791 (FUJI DENKI SOUGOU KENKYUSHO K.K.) 27 November 1984,
- PATENT ABSTRACTS OF JAPAN vol. 10 no. 87 (E-393) [2144] ,5 April 1986 & JP-A-60 233817 (OOSAKA HENATSUKI K.K.) 20 November 1985,

## Description

The present invention relates to a method suitable for continuously forming deposited films on a belt-like substrate by plasma CVD (glow discharge). More particularly, the present invention relates to a method for forming deposited films suitable to mass=produce functional devices, such as solar cells or sensors, that are photoelectric transfer devices using an amorphous semiconductor.

In recent years, consumption of electric power has been rapidly increased all over the world and electric power has been produced flourishingly. However, it leads to problems that thermal power generation and nuclear electric power generation cause environmental pollution and global warming to occur. On the other hand, solar cell power generation using sunlight does not raise the problems of environmental pollution, global warming and maldistribution of resources. Therefore, solar cell power generation is worthy of note to meet a further large consumption of electric power.

To realize solar cell power generation, the solar cell must have a satisfactory photoelectrical conversion efficiency and stable characteristics while being suitable to mass production so as to be supplied cheaply. Furthermore, a solar cell having a large area is required because of the enhanced scale of the power generation. Therefore, it has been proposed that an amorphous silicon type solar cell is formed by depositing a semiconductor thin film, such as amorphous silicon, which is a non-single-crystal, on a relatively low cost substrate, such as glass or a metal sheet, by decomposing a raw material gas of silane or the like available easily by glow discharge. The amorphous silicon type solar cell exhibits excellent mass production yield and lower cost as compared with a solar cell manufactured from single-crystal silicon, thus attracting attention. Thus, a variety of manufacturing methods have been proposed.

Solar cell power generation apparatus usually has a structure that unit modules of solar cells, which are photovoltaic devices, connected in series or in parallel to be formed into a unit so that a desired electric current and voltage are obtained. Therefore, disconnection and short circuit in each unit module must be prevented. Furthermore,nonuniformity of output voltage and electric currents between the unit modules must be prevented. To meet these requirements, the characteristics of the semiconductor, which are the most important factor for determining the characteristics of the unit module, must have uniformity. To simplify the process for assembling the module, a deposited film of a semiconductor must be formed over a large area and must have excellent characteristics. Thus, the mass production yield of the solar cell can be improved and the manufacturing cost can be significantly reduced.

The semiconductor, which is an important component of the solar cell, includes semiconductor junctions, such as p-n junction, p-i-n junction or the like. The foregoing semiconductor junctions can be formed by sequentially depositing semiconductors having different conductive types, or by implanting into a semiconductor having a certain conductive type dopants having a different conductive type or by thermal diffusion. When the amorphous silicon type solar cell is manufactured, a known method with the following steps is employed: mixing a raw material gas containing elements as dopants such as phosphine (PH₃), diborane (B₂H₆) or the like with a silane gas or the like which is the main raw material gas; decomposing the mixed raw material gases by glow discharge to form semiconductor films having desired conductive types; and sequentially depositing the thus-obtained semiconductor films on a desired substrate to easily obtain a semiconductor junction. Therefore, when the amorphous silicon type solar cell is manufactured, diffusion of the dopants having different conductive types is generally prevented by providing independent film forming chambers corresponding to semiconductors to be formed and forming the semiconductors in the corresponding film forming chambers.

As a method of forming a deposited film by a plasma CVD method suitable to manufacture an amorphous silicon type solar cell of the foregoing type, a method adapted to a roll-to-roll method has been disclosed in U.S. Patent No. 4,400,409. The foregoing deposited film forming method comprises the steps of disposing a plurality of glow discharge regions along the passage for an elongated (belt-like) substrate, and continuously conveying the elongated substrate in its longitudinal direction while forming semiconductors respectively having desired conductive types in the corresponding glow discharge regions. According to the disclosure above, solar cells having desired semiconductor junctions can be formed continuously. The foregoing method of forming the deposited film has a structure for preventing diffusion and mixture of the dopant gas for use in each glow discharge region into other glow discharge regions, the structure being arranged such that the respective glow discharge regions are mutually separated from one another by slit-like separation passages called gas gates and that sweeping gas flows of, for example Ar or H₂, are formed to flow through the separation passages. As a result of employing the above structure, the roll-to-roll method for forming a deposited film is suitable to manufacture the semiconductor device for the solar cell or the like.

On the other hand, a fact has been known that the photoelectrical conversion efficiency of the amorphous silicon type solar cell can be improved in a case where a IV-group alloy semiconductor, such as a-SiGe:H, a-SiGe:F, a-SiGe:H:F, a-SiC:H, a-SiC:F or a-SiC:H:F is used as the i-type (intrinsic type) semiconductor by continuously and arbitrarily changing the forbidden band (band gap: Egopt) of the i-type semiconductor in the direction of the thickness from the light incident portion to improve the open voltage (Voc) and curve factor (fill factor: FF) of the solar cell (20th IEEE PV SEC, "A Novel Design for Amorphous Silicon Solar Cells", S. Guha, J. Yang, et al.).

Hitherto, the process for continuously forming deposited film having a large area involves diffusion of impurities into the i-type semiconductor due to the rise in the substrate temperature and thus the characteristics of the solar cell are impaired. In order to overcome the problem above, a method has been employed in which the substrate temperature is sequentially lowered as the respective semiconductors are deposited during the step of depositing deposited films. However, the conventional method cannot form a deposited film at a substrate temperature suitable for depositing each deposited film. Therefore, the characteristics of the deposited film cannot be used satisfactorily. Therefore, a problem is raised in that the characteristics of the photoelectrical conversion device formed by depositing a plurality of layers have been unsatisfactory.

The foregoing roll-to-roll method for forming a deposited film has the arrangement that the elongated substrate is continuously moved while forming a deposited film. Therefore, improvement in the manufacturing efficiency requires the moving speed of the elongated substrate and the film deposition speed to be raised. However, raising of the speeds leads to deterioration of the characteristics of the photoelectric conversion device.

The film quality of the semiconductor having the i-type conductivity must be improved when the characteristics of the photoelectrical conversion device are intended to be improved. However, it leads to the fact that additional electric power is required to raise the substrate temperature or to enlarge the bias electric power.

However, the enlargement of the additional electric power excessively raises the substrate temperature, and impurities are undesirably diffused into the i-type semiconductor due to annealing of the deposited films. Therefore, by the foregoing roll-to-roll method, it is difficult to improve the characteristics of the photoelectrical conversion device.

As disclosed in U.S. Patent No. 4,389,970 and U.S. Patent No. 4,470,369, the foregoing roll-to-roll method for forming a deposited film controls the substrate temperature at a predetermined level at the time of forming a deposited film.

The aforesaid requirements have been considered and the method of the present invention is proposed as a means of improvement.

Preferred embodiments of the present invention include a process of forming a deposited film which comprises changing a substrate temperature at a rate of a predetermined rate or higher before and after forming a deposited film to prevent undesirable annealing of the semiconductor and to continuously and uniformly form a photoelectric conversion device exhibiting an excellent conversion efficiency on a substrate having a large area.

The method of the present invention is, in common with e.g. the method disclosed in United States Patent US-A-4951602, or in European Patent Application EP-A-0406690, a method of forming a deposited film which is performed by steps of supplying a substrate having thereon a film of p-type or n-type conductivity semiconductor; and forming, by glow discharge, on said film of p-type or n-type conductivity semiconductor, a film of i-type conductivity semiconductor.

In accordance with the present invention, this method is characterised, according to claim 1, by a step of rapid heating, which is performed immediately prior to performing said step of forming the film of i-type conductivity semiconductor, by which the temperature of the substrate is raised by 10°C to 300°C, at a rate of 4°C/s or higher, and
by a step of rapid cooling the substrate, which is performed immediately following said step of forming the film of i-type conductivity semiconductor, whereby the substrate is cooled by 10°C to 300°C at a rate of 4°C/s or higher and wherein said film of i-type conductivity semiconductor is formed on said film of p-type or n-type conductivity semiconductor at a deposition rate of 0.1nm/second and 20nm/second and at a temperature of 100°C to 450°C.

In the steps of rapid heating and rapid cooling, the changing of the temperature of the substrate is so rapid that annealing of the deposited film is effectively prevented.

Following the aforesaid step of rapid cooling, a film of n-type or p-type conductivity semiconductor may be formed on the deposited i-type conductivity semiconductor film to produce a pin or nip junction device.

This method may be carried out as a continuous process and is thus well suited to mass production. In this case the substrate may have a belt-like form and would be moved continuously in its lengthwise direction while the method is performed. The steps of rapid heating, forming by glow discharge, and rapid cooling, may all be performed in a common vacuum chamber. In such an arrangement the rapid heating is best applied immediately before the inlet of the glow discharging region in the vacuum chamber, and the rapid cooling immediately after the outlet of the glow discharging region.

In the accompanying drawings:-
Fig. 1 is a schematic view which illustrates an apparatus to implement a process of forming a deposited film performed according to an embodiment of the present invention;
Fig. 2 is a schematic view which illustrates an alternative apparatus for forming a deposited film;
Figs. 3 to 5 are schematic views showing unit parts of an apparatus for forming a deposited film;
Fig. 6 is a schematic view showing the structure of a solar cell which is a photovoltaic device;
Fig. 7 is a schematic view showing the structure of another solar cell which is a photovoltaic device;
Fig. 8 is a schematic view showing the structure of another solar cell which is a photovoltaic device;
Fig. 9 is a schematic view showing the structure of another solar cell which is a photovoltaic device;
Fig. 10 is a schematic view showing the structure of another solar cell which is a photovoltaic device;
Figs. 11a to 11C are schematic views which illustrates a heating means for heating a substrate; and
Figs. 12A to 12C are schematic views which illustrate a cooling means for cooling a substrate.

Preferred embodiments of the present invention will now be described in particular detail and reference will be made to the accompanying drawings listed as aforesaid.

When a semiconductor having p-type or n-type conductivity in a solar cell having p-i-n structure is annealed at a temperature higher than that of the substrate during a film formation, doping atoms such as boron or the like in the semiconductor layer having p-type conductivity (hereinafter referred to as "pt-type layer") and doping atoms such as phosphorus or the like in the semiconductor layer having n-type conductivity (hereinafter referred to as "n-type layer") diffuse in the semiconductor layer having i-type conductivity (hereinafter referred to as "i-type layer"). It can be considered that the foregoing fact is the cause of the deterioration of characteristics of the solar cell formed by depositing a plurality of p-i-n structures. The inventors of the present invention have studied and found that the quantity of diffusion of boron atoms in a semiconductor having p-type conductivity and doping atoms such as phosphorus or the like in a semiconductor having n-type conductivity into the i-type layer can be prevented by rapidly changing a substrate temperature during deposition of the n-type layer to a substrate temperature during deposition of the i-type layer, for example, deposition of the i-type layer temperature of the substrate when both temperatures are different from each other. Although the mechanism of this phenomenon has not been clarified yet, it can be considered that the rapid temperature change causes a kind of a non-equilibrium state to occur (where the equilibrium state means a state in which impurities in the p-type layer or the n-type layer are diffused in the i-type layer due to heat or the like and no density distribution takes place). As a result, the diffusion of impurity atoms can be prevented even when the film forming temperature is raised. In particular, a fact has been known that amorphous silicon semiconductor comprises the deposited film that contains hydrogen atoms which relate to the diffusion of impurities. The rapid temperature change causes a certain kind of a non-equilibrium state to occur between the structure having silicon atoms, the diffusion of hydrogen atoms and the diffusion of impurity atoms so that the diffusion of impurities is prevented.

Therefore, even if the deposition temperature for the i-type layer in a case that a film forming temperature during deposition of the n-type layer is moderately changed to that during deposition of the i-type layer is higher than the deposition temperature for the i-type layer in a case that a film forming temperature during deposition of the n-type layer is rapidly changed to that during deposition of the i-type layer, it can be said that the deposited film subjected to the rapid temperature change is relatively free from impurities.

The present invention is found based on the foregoing fact. In order to effectively use the foregoing fact, a further study was made, thus resulting in a knowledge to be obtained in that diffusion of impurities between semiconductor layers can be effectively prevented by causing rapid temperature change to occur between deposited layers and then forming a deposited film at a high deposition speed. In the present invention the rate in the change of the temperature of the substrate is 4°C/second or higher. The optimum deposition speed capable of effectively utilizing this rapid temperature change is 0.1 nm/second to 20 nm/second.

In performing the rapid temperature change, the difference between the temperatures of the substrates for respective deposited layers is 10°C to 300 °C.

### Substrate

The preferred material for a substrate according to the present invention is required to be free from deformation and distortion at a temperature required to form the deposited layer and to have a desired strength and conductivity. Specifically, the preferred material is exemplified by a thin metal film of stainless steel, aluminium, aluminium alloy, iron, iron alloy, copper and copper alloy, their combination; any of the foregoing thin films of a type whose surface is coated with another metal thin film and/or an insulating thin film, such as SiO₂, Si₃N₄, Al₂O₃ , AIN or the like by either sputtering evaporation or plating; a heat resistant resin sheet of polyimide, polyamide, polyethylene terephthalate, epoxy resin or the like; or a composite of any of the foregoing heat resistant resins and glass fibre, carbon fibre, boronfibre, metal fibre or the like whose surface is subjected to a conductive treatment with a sole metal material, an alloy and a transparent conductive oxide by plating, evaporation, sputtering or application.

It is preferable that the thickness of the substrate is minimized in terms of saving cost and space as long as the strength capable of maintaining a curved shape formed when the substrate is moved can be obtained. Specifically, the thicknessmay be 0.01 mm to 5 mm, preferably 0.02 mm to 2 mm, and most preferably 0.05 mm to 1 mm. In the case where a metal thin film is used, the desired strength can easily be obtained even if the thickness is relatively thin.

The width of the substrate is not limited particularly, the width being determined based on the size of a vacuum chamber or the like.

The length of the substrate is not limited particularly. The substrate may have a length which allows the substrate to be wound into a roll form or a length realized by further elongating an elongated substrate by welding or the like.

In this embodiment the substrate is heated and cooled in a short time. Since it is unsatisfactory that the temperature distribution occurs in the lengthwise direction of the substrate, it is preferable that the heat conduction in the direction in which the substrate is moved be minimized. To cause the temperature of the substrate to follow heating and cooling, it is preferable that the heat conduction be performed considerably in the direction of the thickness of the substrate.

The heat conduction can be limited in the moving direction and made large in the direction of the thickness of the substrate by reducing the thickness. In a case where the substrate has a uniform thickness, it is preferable that (heat conduction) x (thickness) be 1 x 10⁻¹ W/K or less, and more preferably 1 x 10⁻¹ W/K or less.

### Methods for Heating Substrate and for Cooling the Same

In the present invention, a substrate may be heated and cooled by heat conduction in that a means for heating and cooling the substrate is brought into contact with the substrate,or by heat radiation in that the means for heating and cooling the substrate is positioned away from the substrate. The substrate may be heated and cooled from its surface on which the deposited film is formed,or the reverse side of the surface. The specific heat, the thermal conductivity and the moving speed of the substrate are considered to control the temperature distribution of the means for heating and cooling the substrate for the purpose of obtaining a desired rate of the change of the substrate temperature. In a case where a means for heating and cooling the substrate that is moved together with the substrate is used to control the substrate temperature, the temperature to be controlled by the means for heating and cooling the substrate is changed in accordance with the movement of the substrate.

As a concrete method for heating a substrate, heating by a heater such as a halogen lamp, a resistive heating member or the like, by contact with a hot gas plasma or by inductive heating by means of electromagnetic waves may be employed. As a concrete method for cooling a substrate, cooling by radiating heat to a cooling member cooled by air or water, or by spray of cold gas may be employed.

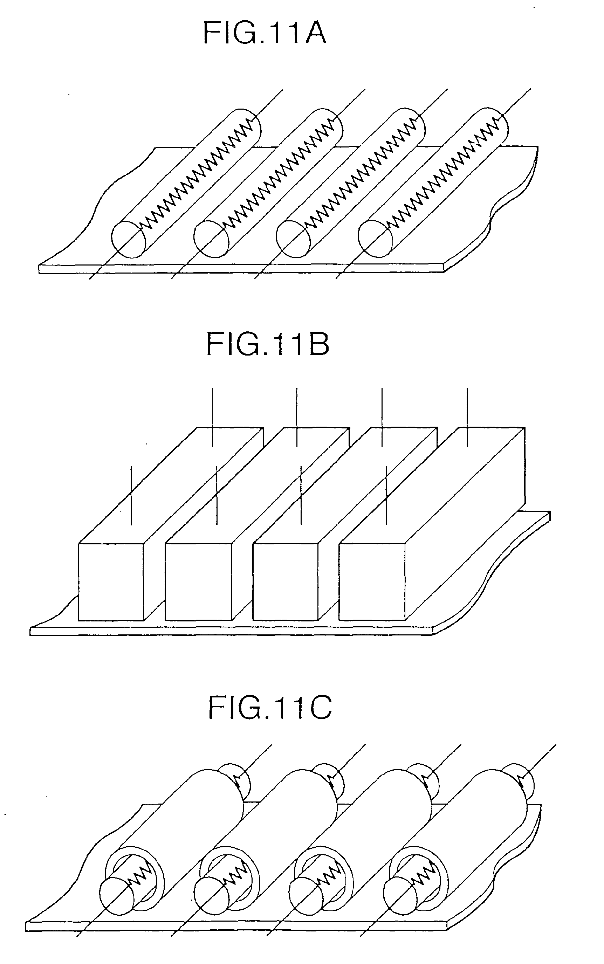

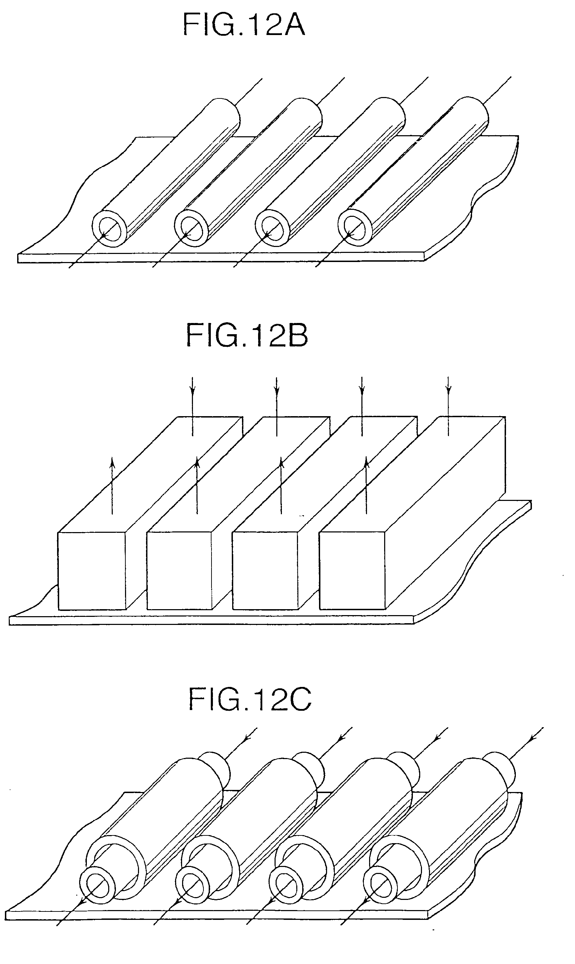

Figs. 11A to 11C are schematic views which illustrate examples of a method for heating a substrate. Fig. 11A illustrates infrared ray heating using halogen lamps, Fig. 11B illustrates heating by bringing a heating block into contact with a substrate, Fig. 11C illustrates heating by bringing a heating roller into contact with a substrate. Figs. 12A to 12C are schematic views which illustrate examples of a method for cooling the substrate. Fig. 12A illustrates cooling by using a cooling pipe which is disposed adjacent to the substrate and through which a medium such as water passes through as a cooling medium, Fig. 12B illustrates cooling by bringing a cooling block of water or the like, which is a cooling medium, into contact with the substrate, and Fig. 12C illustrates cooling by bringing a cooling roller of water or the like, which is a cooling medium, into contact with the substrate.

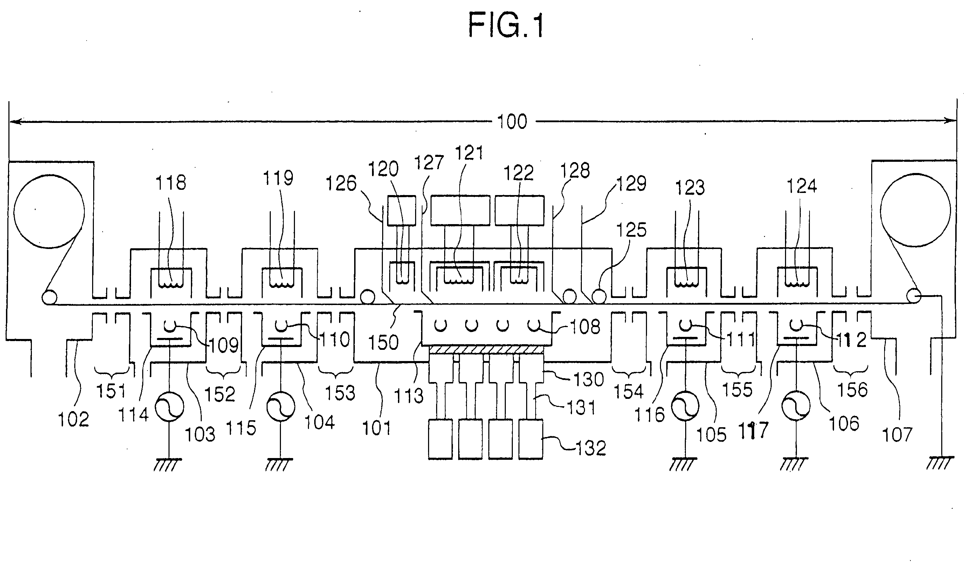

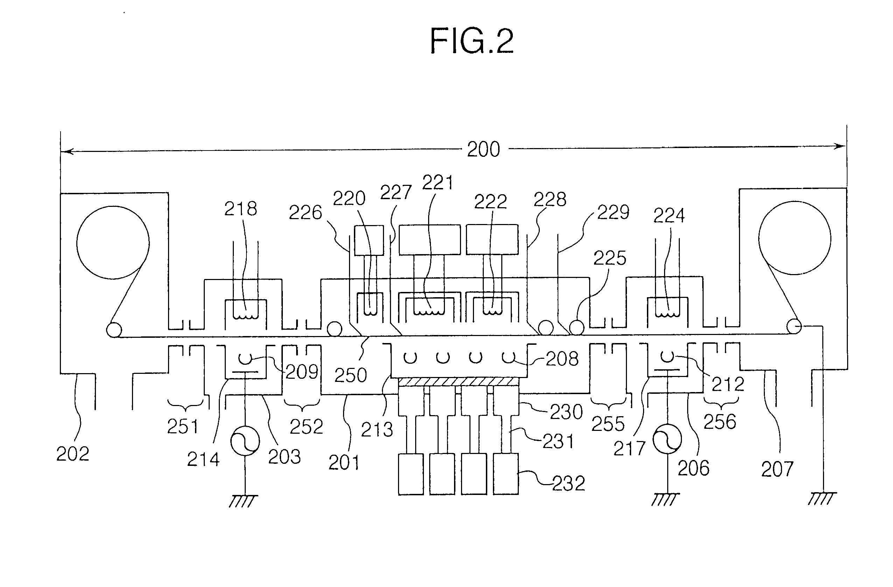

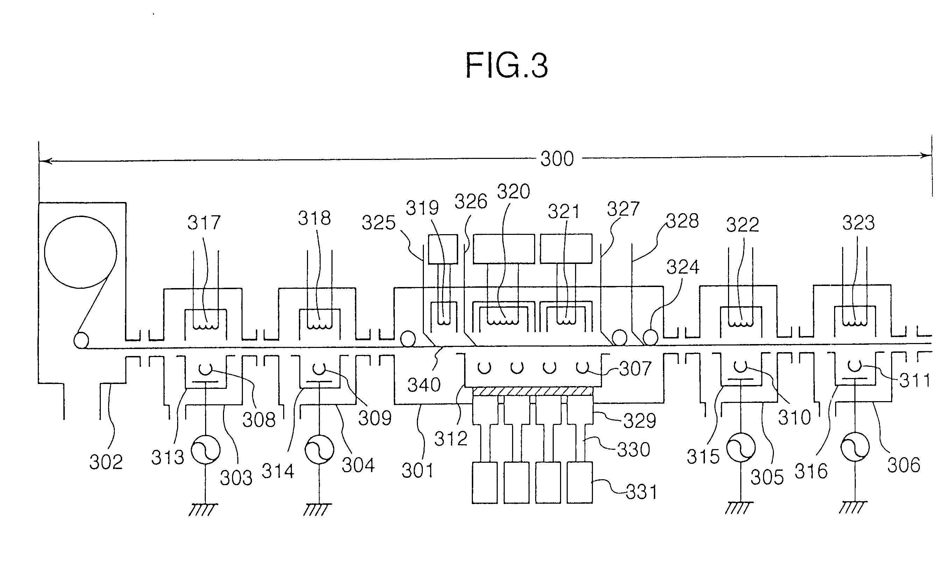

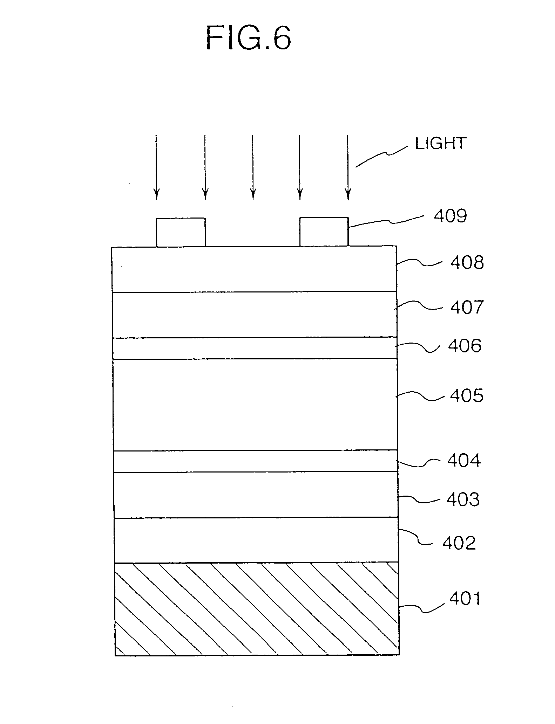

Fig. 1 is a schematic cross sectional view which illustrates the structure of a deposited film-forming apparatus for use in a process for forming a deposited film according to an embodiment of the present invention. Fig. 2 is a schematic cross sectional view illustrates the structure of a deposited film-forming apparatus for use in a process for forming a deposited film according to another embodiment of the present invention. Figs. 3 to 5 are schematic cross sectional views which illustrate the structure of an apparatus for continuously forming a deposited film which has the deposited film-forming apparatus shown in Fig. 1. Figs. 6 to 10 are schematic cross sectional views which illustrate the layer structures of a solar cell which are various kind of photoelectrical conversion devices.

A continuous deposited film-forming apparatus 100 shown in fig. 1 is suitable to form a semiconductor having an n-i-p junction on an elongated (belt-like) substrate 150. The continuous deposited film-forming apparatus 100 comprises a substrate feeding chamber 102, an n-type layer-forming vacuum chamber 103, an RF (hereinafter high frequency plasma CVD is referred to as "RF") i-type (n-side) layer-forming vacuum chamber 104, an MW (hereinafter microwave plasma CVD is referred to as "MW") i-type layer-forming vacuum chamber 101, an RFi-type (p-side) layer-forming vacuum chamber 105, a p-type layer-forming vacuum chamber 106 and a substrate winding chamber 107 that are connected in series by six gas gates 151, 152, 153, 154, 155 and 156. A gate gas supply pipe for supplying a gate gas is connected to each of the gas gates 151, 152, 153, 154, 155 and 156.

The substrate feeding chamber 102 stores the elongated substrate 150 to supply it to the substrate winding chamber 107. A bobbin, around which the elongated substrate 150 is wound, is bonded to the substrate feeding chamber 102. Furthermore, the substrate feeding chamber 102 has conveyance rollers for supporting and conveying the elongated substrate 150, while a substrate feeding mechanism for feeding the elongated substrate 150 and an exhaust pipe connected to an exhaust means (not shown) are connected to the bobbin.

The MWi-type layer-forming vacuum chamber 101 comprises a substantially cubical vacuum chamber and a discharging chamber 113 disposed in the vacuum chamber. The vacuum chamber 101 and the discharging chamber 113 are made of metal and are electrically grounded. The elongated substrate 150, on which the deposited film will be formed, is allowed to pass through the left portion of the vacuum chamber 101 in the drawing, that is, the gas gate 153 attached to the side wall of the inlet portion of the vacuum chamber 101, the elongated substrate 150 being then introduced into the vacuum chamber 101. Then, the elongated substrate 150 is allowed to pass through the discharging chamber 113 and conveyed outside the vacuum chamber 101 through the right portion of the vacuum chamber 101 in the drawing, that is, the gas gate 154 attached to the side wall of the outlet portion of the vacuum chamber 101. A gate gas supply pipe (not shown) for supplying a gate gas is connected to each of the gas gates 153 and 154. The elongated substrate 150 is continuously moved through the vacuum chamber 101 from the gas gate 153 toward the gas gate 154.

In the vacuum chamber 101, there are disposed an infrared-ray lamp sensor 120 for heating the elongated substrate 150, which is moved continuously, prior to entering into the discharging chamber 113, an infrared-ray lamp heater 121 for heating the elongated substrate 150 immediately prior to entering into the inlet of the discharging chamber 113, and a water cooling pipe 125 for cooling the elongated substrate 150 immediately after passing the outlet of the discharging chamber 113, each of the foregoing units being controlled by a corresponding temperature control unit (not shown). Furthermore, thermocouples 126, 127, 128 and 129 for measuring the substrate temperature at predetermined positions in the vacuum chamber 101 are disposed to be in contact with the reverse side of the elongated substrate 150 which is being moved. We shall say that thermocouple 127 is disposed "immediately before" the inlet of the discharging chamber 113 when it is disposed within 1 cm, and that it is disposed "in the vicinity of" the inlet of the discharging chamber 113 when it is disposed at a distance of about 10 cm from the inlet.

The discharging chamber 113 includes a gas introduction pipe 108 for introducing a raw material gas for a deposited film from a gas supply system (not shown). An exhaust pipe connected to an exhaust unit (not shown) is attached to the wall of the vacuum chamber 101 on the rear side in the drawing. Applicators 130 are arranged on the wall of the discharging chamber 113 that faces the elongated substrate 150, in a direction in which the elongated substrate 150 is moved. The applicators 130 introduce microwave energy into the discharging chamber 113 and each is connected to an end of a wave introduction pipe 131, the other end of which is connected to a microwave power source 132. Portions of each applicator 130 attached to the discharging chamber 113 are formed into microwave introduction windows made of a microwave-transmissive material such as quartz, alumina ceramic or the like.

The vacuum chambers 103, 106, 104 and 105 for respectively forming n-type, p-type, RFi-type (n-side) and RFi-type (p-side) layers have the same structures so that n-type, p-type, i-type and i-type semiconductor layers respectively are formed. An exhaust pipe connected to an exhaust means (not shown) is attached to each vacuum chamber. Each of the vacuum chambers 103, 106, 104 and 105 respectively have discharging chambers 114, 117, 115 and 116 therein. The discharging chambers 114, 117, 115 and 116 include gas introduction pipes 109, 112, 110 and 111, a discharge electrode connected to a high frequency power source and infrared-ray lamp heaters 118, 124, 119 and 123 for heating the moving substrate 150.

The substrate winding chamber 107 winds up the elongated substrate 150 on which the deposited film has been formed, the substrate winding chamber 107 having a similar structure to that of the substrate feeding chamber 102 in that an exhaust pipe is connected to the substrate winding chamber 107, and a substrate winding bobbin and substrate conveying rollers are provided. A substrate winding mechanism for winding up the elongated substrate 150 is connected to the bobbin.

The operation of the continuous deposited film-forming apparatus 100 will now be described mainly in a case where a semiconductor having an n-i-p junction will be formed.

Initially, the elongated substrate 150 is arranged between the substrate feeding chamber 102 and the substrate winding chamber 107 so as to be moved continuously at a predetermined speed. Then, gases are discharged from the substrate feeding chamber 102, the vacuum chambers 103, 106, 104, 105 and 101 for respectively forming n-type, p-type, RFi-type (n-side), RFi-type (p-side) and MWi-type layers and the substrate winding chamber 102 to obtain a predetermined degree of vacuum. Then, gate gases are supplied to the gas gates 151, 152, 153, 154, 155 and 156.

Then, in the MWi-type layer-forming vacuum chamber 101, the infrared-ray lamp heaters 120, 121 and 122 and the cooling pipe 125 are operated while monitoring the outputs from the thermocouples 126 to 129 so that the moving elongated substrate 150 is heated and cooled to obtain a predetermined temperature distribution in the discharging chamber 113. While introducing the raw material gas for forming the deposited film into the discharging chamber 113 through the gas introduction pipe 108, microwave electric power is introduced through the microwave introduction window 130. Thus, a microwave glow discharge takes place in the discharging chamber 113, causing plasma to be generated. As a result, a deposited film is formed on the moving elongated substrate 150.

In the case where a semiconductor layer for manufacturing a photovoltaic device is formed by a microwave plasma CVD, the preferred conditions are as follows: the substrate temperature in the deposition chamber is 100°C to 450°C, the internal pressure in the deposition chamber is 6.7 x 10⁻² Pa (0.5 mTorr) to 4.0 Pa (30 mTorr), the microwave power is 0.01 W/cm³ to 1 W/cm³ and the frequency of the microwave is 0.5 GHz to 10 GHz.

To improve the characteristics of a semiconductor layer for a photovoltaic device, which is a photoelectrical conversion device, high frequency bias electric power is sometimes introduced into a microwave glow discharging region in the discharging chamber 113. The introduction of the high frequency bias further activates active species in the glow discharging region so that a substrate is annealed. As a result, boron atoms in the p-type layer and the phosphorus atoms in the n-type layer diffuse in the i-type layer, causing the characteristics of a solar cell to be impaired. Therefore, it is preferable that the deposition speed be 0.2 nm/second or higher in the case where a semiconductor layer is deposited by microwave plasma CVD.

The elongated substrate 150 is heated immediately before the inlet of the discharging chamber 113 by the infrared-ray lamp heater 120, while it is cooled by the cooling pipe 125 immediately after the outlet of the discharging chamber 113. Therefore, the change rate of the substrate temperature per one hour can be changed arbitrarily before and after the deposited film is formed.

Also in the n-type, p-type, RFi-type (n-side) and RFi-type (p-side) layer-forming vacuum chambers 103, 106, 104 and 105, raw material gases for forming a deposited film are introduced into the discharging chambers 114, 117, 115 and 116 through the corresponding gas introduction pipes 109, 112, 110 and 111. Then, high frequency electric power is supplied from the high frequency power source to the discharging electrode so that high frequency glow discharge is caused to take place between the discharging electrode and the grounded conductive substrate 150 and thus plasma is generated.

In the case where the deposition is performed by high frequency plasma CVD, the preferred conditions are as follows: the substrate temperature in the deposition chamber is 100°C to 350°C, the internal pressure in the deposition chamber is 1.3 x 10 Pa (0.1 Torr) to 1.3 x 10³ Pa (10 Torr) the RF power is 0.01 W/cm² to 5.0 W/cm² and the deposition rate is from 0.01 nm/s (0.1 Å/s) to 3nm/s 30 Å/s).

As a result, the raw material gases in the discharging chambers 114, 117, 115 and 116 are decomposed so that a deposited film is formed on the elongated substrate 150.

Since the elongated substrate 150 is moved continuously through n-type, p-type, RFi-type (n-side) and RFi-type (p-side) layer-forming vacuum chambers, a semiconductor having an n-i-p junction is formed on the substrate 150.

Since the raw material gas for the deposited film is introduced through the gas introduction pipe and is exhausted through the exhaust pipe disposed on the wall on the reverse side of the discharging chamber, substantially no raw material gas flows in the discharging chamber in the direction of the moving substrate. Thus, the degree of decomposition of the raw material gas is substantially uniform in the direction of the moving substrate. Therefore, variation in the band gap of the deposited film depending on the degree of the decomposition of the raw material gas in the direction of the moving substrate can be prevented.

The experimental results of the present examples will now be described specifically with reference to experimental data. Since the experimental examples to be described now are performed in the case where the process for forming a deposited film according to the present invention is employed to manufacture an amorphous silicon solar cell or to form an amorphous silicon semiconductor film which is a constituent element of the solar cell, the amorphous silicon solar cell will now be described with reference to Figs. 6 to 10.

The solar cell, which is a photoelectrical conversion device, shown in Fig. 6 has a structurehaving a lower electrode 402, an n-type semiconductor 403, a RFi-type (n-side) semiconductor 404, an MWi-type semiconductor 405, an RFi-type (p-side) semiconductor 406, a p-type semiconductor 407, a transparent electrode 408 and collecting electrode 409 sequentially formed on a substrate 401. The foregoing solar cell is intended to receive incident light from the side of the transparent electrode 408. The lower electrode 402 is an electrode opposed to the transparent electrode 408 through the semiconductors 403 to 407.

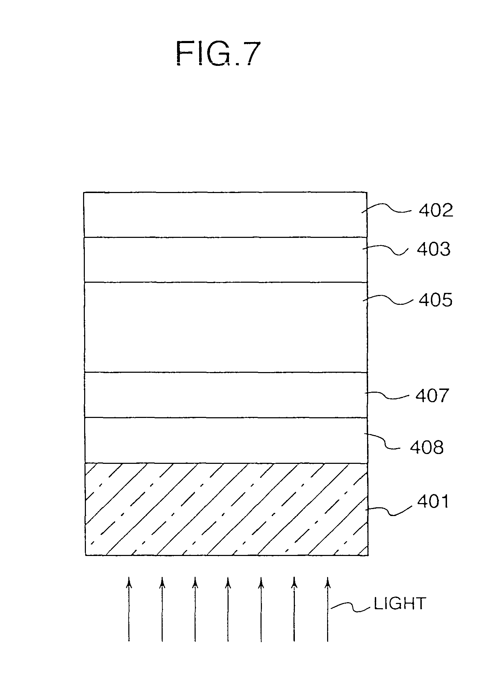

The solar cell, which is a photoelectrical conversion device, shown in Fig. 7, comprises the substrate 401 which is a light-transmissive substrate, the solar cell being arranged to receive incident light from the side of the substrate 401. The solar cell shown in Fig. 7 has a structure having a transparent electrode 408, a p-type semiconductor 407,a MWi-type semiconductor 405,an n-type semiconductor 403 and a lower electrode 402, sequentially deposited on the substrate 401.

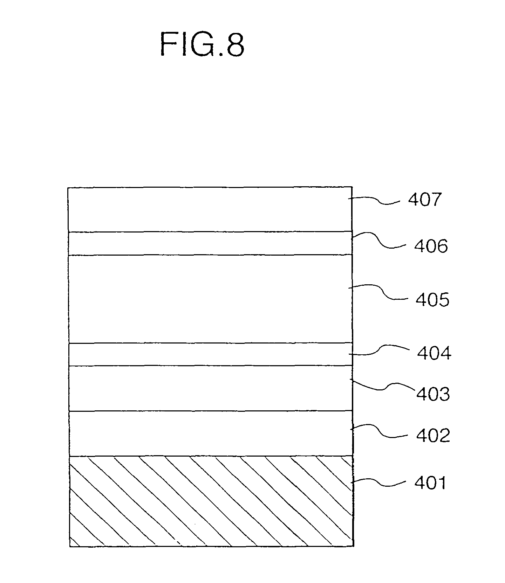

The solar cell, which is a photoelectrical conversion device shown in Fig. 8, has a structure having a lower electrode 402,an n-type semiconductor 403, an RFi-type (n-side) semiconductor 404, a MWi-type semiconductor 405, an RFi-type (p-side) semiconductor 406 and a p-type semiconductor, sequentially formed on the substrate 401.

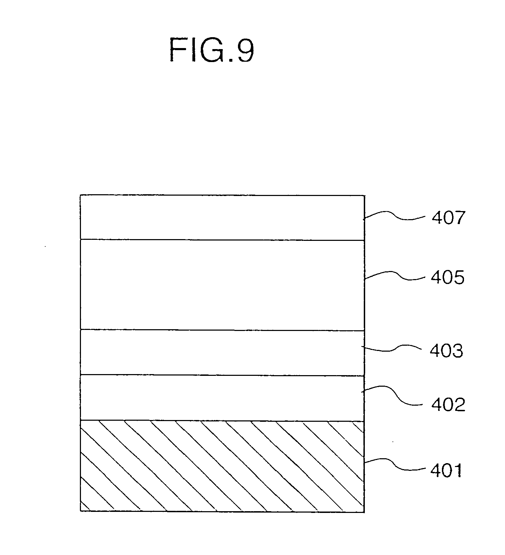

The solar cell, which is a photoelectrical conversion device shown in fig. 9, has a structure having a lower electrode 402, an n-type semiconductor 403, an MWi-type semiconductor 405 and a p-type semiconductor 407, formed sequentially on the substrate 401.

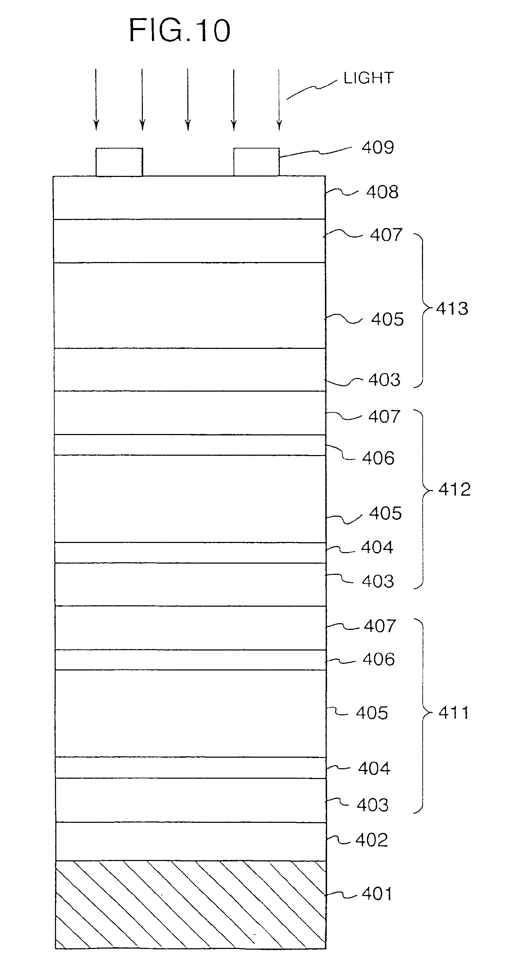

Although each of the foregoing solar cells has only one p-i-n junction, two or more p-i-n junctions may be deposited in order to improve the efficiency of using incident light. Fig. 10 illustrates the structure of a solar cell (a so-called triple-type solar cell) having three p-i-n junctions. The foregoing solar cell has the structure: a lower electrode 402, a first semiconductor region 411 having a first p-i-n junction, a semiconductor region 412 having a second p-i-n junction, a semiconductor region 413 having a third p-i-n junction, a transparent electrode 408 and a collecting electrode 409, sequentially deposited on the substrate 401. Light is made incident from the side of the transparent electrode 408. Also, in the foregoing solar cell the band gap and the film thickness of the i-type semiconductor 405 are made to be different in each p-i-n junctions 411 to 413 in order to improve the photoelectrical conversion efficiency.

The detailed structure of the foregoing constituent element of the solar cell will now be described. In each of the solar cells shown in Figs. 6 to 10, the n-type semiconductor 403 and the p-type semiconductor 407 are arranged such that the p-type semiconductor 407 is positioned more adjacent to the light incidence position. However, a layer structure may be employed in which the n-type semiconductor 403 is positioned more adjacent to the light incidence position.

First, the substrate 401, which is the substrate of the solar cell, will now be described.

It is preferable that the substrate 401 of the solar cell of a material which can be bent easily and with which a curved shape can easily be formed, the material being permitted to be a conductor or insulator. Although the substrate 401 may be light-transmissive or non-light-transmissive the substrate 401 must, or course, be light-transmissive with respect to, at least, light having the wavelength that is absorbed by the semiconductor. Specifically, the substrate 401 is exemplified by the foregoing elongated substrate 150. By using the elongated substrate 150, the weight of the solar cell to be manufactured can be reduced, the strength of the same can beimproved and the space required to transport the solar cell can be saved.

Next, the electrodes for taking electric power from the solar cell will now be described.

In the solar cell
the electrodes are selected arbitrarily depending on their structure. The electrodes are exemplified by the lower electrode 402, the transparent electrode 408 and the collecting electrode 409 (provided that the transparent electrode 408 is an electrode disposed on the light incident side and the lower electrode 402 is an electrode opposed to the transparent electrode 408 through the semiconductors 403 to 407).

The foregoing electrodes will now be described in detail.

### (i) Lower Electrode 402

The position at which the lower electrode 402 is disposed depends upon whether the material of the substrate 401 is light transmissive, because this determines the side on which light for generating the photovoltaic power is applied. (In a case where the substrate 401 is made of a material such as metal or the like which is a non-light-transmissive material, light is applied from a position through the transparent electrode 408, as shown in Fig. 6.)

Specifically, in a case of a layer structure shown in any of Figs. 6, 8, 9 or 10, the lower electrode 402 is, as an electrode for taking an electric current, disposed between the substrate 401 and the n-type semiconductor 403. In a case where the substrate 401 is conductive, the substrate 401 is able to also serve as the lower electrode 402. Therefore, the lower electrode can be omitted from the structure. However, in a case where the substrate 401 has conductivity as well as a large sheet resistance, an electrode having a small resistance for taking an electric current or the lower electrode 402 for the purpose of raising the reflectance on the surface of the support member to efficiently use incident light may be provided.

In the case shown in Fig. 7, a light transmissive substrate 401 is used and light is made incident upon from the side of the substrate 401. Therefore, the lower electrode 402 is disposed to oppose the substrate 401 through the semiconductors 403 to 407 in order to take an electric current and to reflect light.

The material of the lower electrodes 402 is exemplified by metal, such as Ag, Au, Pt, Ni, Cr, Cu, A1, Ti, Zn, Mo, W, or the like or their alloy. A thin film of any of the foregoing materials is formed by any of vacuum evaporation, electron beam evaporation or sputtering. The formed metal thin film must be arranged not to be a resistance component with respect to the output from the solar cell. Thus, it is preferable that the sheet resistance of the lower electrode 402 be 50 **Ω/□** or lower, and more preferably 10 Ω/□ or lower.

Between the lower electrode 402 and the n-type semiconductor 403 there may be provided a diffusion preventive layer (not shown), such as zinc oxide having conductivity. The diffusion preventive layer has the effect of preventing diffusion of metal elements constituting the lower electrode 402 into the n-type semiconductor 403. Further, by having some resistance it is able to prevent a short circuit between the lower electrode 402 and the transparent electrode 408 due to a defect such as a pinhole generated in each of the semiconductors 403 to 407. Furthermore, the thin film causes a multi-interference to take place so that incident light can be enclosed in the photoelectrical conversion device. Furthermore, the lower electrode 402 itself is formed by a transparent conductive member such as ZnO, SnO₂, ITO or the like.

### (ii) Transparent Electrode 408

It is preferable that the transparent electrode 408 has a light transmissivity of 85 % or more in order to cause light energy from the sun or a white fluorescent lamp to be efficiently absorbed by the semiconductors 403 to 407. Furthermore, it is electrically preferable that the sheet resistance of the transparent electrode 408 be 100 Ω/□ or less, in order to prevent the transparent electrode 408 acting as a resistance component with respect to the output from the solar cell. A material having the foregoing characteristics is exemplified by a metal oxide, such as SnO₂, In₂O₃, ZnO, CdO, Cd₂SnO₄, ITO (In₂O₃ + SnO₂) or the like; and a thin metal film formed by considerably thinning a metal, such as Au, Al, Cu or the like, into a semitransparent film. The transparent electrode 408 is formed on the p-type semiconductor 407 of the solar cell shown in any of Figs. 6, 8 and 9. The transparent electrode 408 is, in the solar cell shown in Fig. 7, formed on the substrate 401. Therefore, excellent adhesion is required between the transparent electrode 408 and the corresponding surface. The transparent electrode 408 can be manufactured by resistance heat evaporation, electron beam heat evaporation, sputtering (direction sputtering or indirect sputtering), spraying or the like.

### (iii) Collecting Electrode 409

The collecting electrode 409 is, in the form of a lattice, formed on the transparent electrode 408 for the purpose of effectively reducing the surface resistance of the transparent electrode 408. The collecting electrode 409 may be made of any of a metallic material such as Ag, Cr, Ni, Al, Au, Ti, Pt, Cu, Mo, W or the like or their alloys or a conductive paste containing the foregoing metal or metal alloy; and a carbon paste. The foregoing thin films may be laminated, if necessary. To maintain a sufficiently large quantity of light made incident on each of the semiconductors 403 to 407, the shape and the area of the collecting electrode 409 are designed arbitrarily.

It is preferable that the shape of the transparent electrode 408 be such that it is uniformly widened with respect to the light receiving surface of the solar cell and as well as the area of the same with respect to the light receiving area be 15 % or less, and more preferably 10 % or less. It is preferable that the sheet resistance be 50 Ω/□ or less, and more preferably 10 Ω/□ or less.

### (iv) n-type Semiconductor 403, i-type Semiconductors 404 - 406 and p-type Semiconductor 407

The n-type semiconductor 403, the i-type semiconductors 404 - 406 and the p-type semiconductor 407 will be explained below.

The material of the semiconductor is any of a material selected from a group consisting of a material using an element of the group IV such as Si, C, Ge, or the like, or a material using an alloy containing an element of group IV, such as SiGe, SiC, SiSn or the like.

Among the material for the semiconductor, any of the following alloy type semiconductor materials can be preferably employed to manufacture the photovoltaic device
a-Si:H (hydrogenated amorphous silicon), a-Si:F, a-Si:H:F, a-SiGe:H, a-SiGe:F, a-SiGe:H:F, a-SiC:H, a-SiC:F, a-SiC:H:F or the like.

The semiconductor layer may be subjected to valence electron control and forbidden band width control. Specifically, a raw material compound containing an element serving as a valence electron controlling material or a forbidden band width control material is supplied, either solely or in the form of a mixture with the raw material gas for forming the deposited film or a dilution gas before it is introduced into the space for film formation.

The semiconductor layer is, in at least a portion thereof, doped into the p-type or the n-type due to the valence electron control so that at least one p-i-n junction is formed. By depositing a plurality of p-i-n junctions, a so-called stack cell structure is formed.

The semiconductor layer can be formed by various kinds of CVD, such as microwave plasma CVD, RF plasma CVD, photo CVD, heat CVD or MOCVD; various evaporating methods such as EB evaporation, MBE, ion plating or ion beam; sputtering; spraying; or printing. In the industrial view point, plasma CVD having the steps of decomposing the raw material gas and depositing films on the substrate is preferably employed.

Next, the semiconductor using a IV group or IV group type alloy amorphous semiconductor material suitable for use to manufacture the photovoltaic device will now be described.

### (a) i-Type Semiconductors 404 to 406

In a photovoltaic device using amorphous semiconductor material which is a IV-group or IV-group type alloy non-mono-crystal, the i-type layer for use to form the p-i-n junction is an important layer for generating and transporting carriers with respect to irradiation light.

As the i-type layer, a layer having slight p-type or n-type conductivity may be employed.

The alloy type amorphous semiconductor material contains hydrogen atoms (H, D) or halogen atoms (X) as described above that serve as important elements.

Hydrogen atoms (H, D) or halogen atoms (X) contained in the i-type layer compensate dangling bonds of the i-type layer so as to improve the product of the mobility of the carriers in the i-type layer and the life. Furthermore, the foregoing atoms compensate the interfacial level in the interface between the p-type layer and the i-type layer and between the n-type layer and the i-type layer so that the photovoltaic power, photoelectrical electric flow and light response of the photovoltaic device are optimal. An optimum quantity of hydrogen atoms and/or halogen atoms contained in the i-type layer is 1 to 40 atomic%. In particular, hydrogen atoms and/or halogen atoms are preferably distributed in a large quantity in the interface between the p-type layer and the i-type layer and that between the n-type layer and i-type layer. A preferred content of hydrogen atoms and/or halogen atoms in the vicinity of the interfaces is in a range from 1.1 to 2 times the content of these atoms in the bulk. It is preferable that the content of hydrogen atoms and/or halogen atoms be changed in correspondence with the content of silicon atoms.

A preferred semiconductor material constituting the i-type semiconductor layer having the first p-i-n junction in the photovoltaic device is amorphous silicon, while a preferred semiconductor material constituting the i-type semiconductor layer having the second and third p-i-n junctions is amorphous silicon germanium.

The amorphous silicon and the amorphous silicon germanium are expressed depending upon the element that compensates the dangling bond as: a-Si:H, a-Si:F, a-Si:H:F, a-SiGe:H, a-SiGe:F or a-SiGe:H:F.

More specifically, the material of the i-type semiconductor layer 110 having the first p-i-n junction suitable for use in the photovoltaic device is exemplified by i-type hydrogenated amorphous silicon (a-Si:H) preferably having optical characteristics that a band gap (Eg) is 1.60 eV to 1.85 eV; AM is 1.5; the content of hydrogen atoms (CH) is 1.0 to 25.0%; photoconductivity (σp) under pseudo sun light of 100 mW/cm² is 1.0 x 10⁻⁵ S/cm or more; dark conductivity (σd) is 1.0 x 10⁻⁹ S/cm or less; inclination of abacktail by measuring in a Contact Photocurrent Method (CPM) is 55 meV or less; and the local level density is 10¹⁷/cm³ or less.

Amorphous silicon germanium, which is a non-monocrystalline material for forming the i-type semiconductor layers 104 and 107 having the second and the third p-i-n junctions for use in the photovoltaic device has characteristics that the optical band gap (Eg) is 1.20 eV to 1.60 eV; and the content (CH) of hydrogen atoms is 1.0% to 25.0%. To effectively utilize the rapid temperature change, the optimum deposition speed is 0.2 nm/second to 20 nm/second. To realize the foregoing deposition speed and as well as to manufacture the amorphous silicon germanium having the foregoing characteristics, it is preferable that the flow rate of the raw material gas into the discharging space is 0.2 standard litres per minute or more. It is preferable that the flow rate ratio of the gas containing germanium atoms is 40 % or less.

A preferred temperature for forming a deposited film is 100°C to 450°C.

### (b) p-Type Semiconductor Layer 407 and n-Type Semiconductor Layer 403

As the amorphous material (referred to as "a-") of the p-type layer and the n-type layer (a microcrystalline material (referred to as "µc-") is also included in the category of the amorphous material), it is exemplified by a material prepared by adding a p-type valence electron controlling material (B, Al, Ga, In or Tl in the group III of periodic table) or an n-type valence electron controlling material (P, As, Sb or Bi in the group V of the periodic table) at a high concentration to materials such as a-Si:H, a-Si:HX, a-SiC:H, a-SiC:HX, a-SiGe:H, a-SiGeC:H, a-SiO:H, a-SiN:H, a-SiON:HX, a-SiOCN:HX, µc-Si:H, µc-SiC:H, µc-Si:HX, µc-SiC:HX, µc-SiGe:H, µc-SiO:H, µc-SiGeC:H, µc-SiN:H, µc-SiON:HX, µc-SiOCN:HX or the like. The polycrystalline material (referred to as "poly-") is exemplified by a material prepared by adding a p-type valence electron controlling material (B, Al, Ga, In or T1 in the group III of the periodic table) or a n-type valence electron controlling material (P, As, Sb or Bi in the group V of the periodic table) at a high concentration to materials such as poly-Si:H, poly-Si:HX, poly-SiC:H, poly-SiC:HX, poly-SiGe:H, poly-Si, poly-SiC, poly-SiGe or the like.

It is preferable that the p-type layer or the n-type layer on the light incident side be a semiconductor layer which is a crystalline semiconductor layer absorbing light in a small quantity and which has a wide band gap.

An optimum quantity of atoms of group III of the periodic table in the p-type layer and atoms of group V of the periodic table in the n-type layer are 0.1 atomic % to 50 atomic %.

Hydrogen atoms (H, D) or halogen atoms contained in the p-type layer or the n-type layer compensate dangling bonds of the p-type layer or the n-type layer so as to improve the doping efficiency into the p-type layer or the n-type layer. A preferred quantity of hydrogen atoms or halogen atoms to be added to the p-type layer or the n-type layer is 0.1 atomic % to 40 atomic %. In a case where the p-type layer or the n-type layer is a crystalline layer, an optimum quantity of hydrogen atoms or halogen atoms is 0.1 atomic % to 8 atomic %. In particular, hydrogen atoms and/or halogen atoms are preferably distributed in a large quantity in the interface between the p-type layer and the i-type layer and that between the n-type layer and the i-type layer. A preferred content of hydrogen atoms and/or halogen atoms in the vicinity of the interfaces is in a range from 1.1 to 2 times the content of these atoms in the bulk. By causing hydrogen atoms and/or halogen atoms to be contained in a large quantity in the vicinity of the interface between the p-type layer and the i-type layer and between the n-type layer and the i-type layer, defect levels and mechanical distortions in the vicinity of the interfaces can be reduced. Thus, the photovoltaic power and the photoelectric current of the photovoltaic device can be increased.

It is preferable that the electrical characteristics of the p-type layer and the n-type layer of the photovoltaic device be such that the activating energy is 0.2 eV or less, and most preferably 0.1 eV or less. The resistance is preferably 100 Ωcm less, and most preferably 1 Ωcm or less. It is preferable that the thickness of each of the p-type layer and that of the n-type layer be 1 nm to 50 nm, and most preferably 3 nm to 10 nm.

To form the IV-group and IV-group alloy type amorphous semiconductor layer serving as the preferred semiconductor layer of the photovoltaic device, the optimum manufacturing method is a microwave plasma CVD method. Also an RF plasma CVD method may be employed as a second preferable manufacturing method.

The microwave plasma CVD method is a method comprising the steps of: introducing material gases such as the raw material gases and diluting gas into a deposition chamber (a vacuum chamber); making the internal pressure of the deposition chamber to be constant while exhausting by using a vacuum pump; and introducing microwaves generated by a microwave power source through the wave introducing pipe into the deposition chamber through a dielectric window (an alumina ceramic window or the like) to generate plasma of the material gas to decompose the material so that a desired deposited film is formed on a substrate placed in the decomposition chamber. The foregoing method enables a deposited film suitable to form the photovoltaic device to be formed under a wide deposition condition.

The raw material gas suitable to deposit the IV-group and IV-group alloy type amorphous semiconductor layer preferably employed to manufacture the photovoltaic device is, for example,a compound which contains silicon atoms and which can be gasified; a compound which contains germanium atoms and which can be gasified; a compound which contains carbon atoms and which can be gasified; a compound which contains nitrogen atoms and which can be gasified; a compound which contains oxygen atoms and which can be gasified; and their mixture gas.

Specifically, the compound which contains silicon atoms and which can be gasified is a chained or cyclic silane compound exemplified by the following gaseous materials or material that can easily be gasified: SiH₄, Si₂H₆, SiF₄, SiFH₃, SiF₂H₂, SiF₃H, Si₃H₈, SiD₄, SIHD₃, SiH₂D₂, SiH₃D, SiFD₃, SiF₂D₂, SiD₃H, Si₂D₃H₃, (SiF₂)₅, (SiF₂)₆, (SiF₂)₄, Si₂F₆, Si₃F₈, Si₂H₂F₄, Si₂H₃F₃, SiCl₄, (SiCl₂)₅, SiBr₄, (SiBr₂)₅, Si₂Cl₆, SiHCl₃, SiH₂Br₂, SiH₂Cl₂ and Si₂Cl₃F₃.

The compound which contains germanium atoms and which can be gasified is exemplified by GeH₄, GeD₄, GeFH₃, GeF₂H₂, GeF₃H, GeHD₃, GeH₂D₂, GeH₃D, GeH₆, and Ge₂D₆.

The compound which contains carbon atoms and which can be gasified is exemplified by CH₄, CD₄, CₙH_{2n+ 2} (n is an integer), CₙH₂ₙ (n is an integer), C₂H₂, C₆H₆, CO₂ and CO.

The gas containing nitrogen is exemplified by N₂, NH₃, ND₃, NO, NO₂ and N₂O.

The gas containing oxygen is exemplified by O₂, CO, CO₂, NO, NO₂, CH₃CH₂OH and CH₃OH .

The material to be introduced into the p-type layer or the n-type layer to control valence electrons is exemplified by atoms in group III or those in group V of the periodic table.

An effective starting material for the introduction of atoms of group III is exemplified as follows: the material for introducing boron atoms is exemplified by boron hydride such as B₂H₆, B₄H₁₀, B₅H₉, B₅H₁₁, B₆H₁₀, B₆H₁₂ or B₆H₁₄ ; and boron halide such as BF₃ or BCl. Furthermore, AlCl₃, GaCl₃, InCl₃ and TlCl₃ are exemplified. In particular, it is preferable to employ B₂H₆ or BF₃.

An effective starting material for the introduction of atoms in group V is exemplified as follows: the material for introducing phosphorous is exemplified by phosphorous hydride such as PH₃ or P₂H₄; and phosphorous halide such as PH₄I, PF₃, PF₅, PCl₃, PCl₅, PBr₃, PBr₅ or Pl₃. Furthermore, other materials are exemplified: AsH₃. AsF₃. AsCl₃, AsBr₃, AsF₅, SbH₃, SbF₃. SbF₅, SbCl₃, SbCl₅, BiH₃, BiCl₃ and BiBr₃. In particular, it is preferable to employ PH₃ or PF₃.

The foregoing compound, which can be gasified, may be arbitrarily diluted with H₂, He, Ne, Ar, Xe or Kr gas before it is introduced into the deposition chamber.

In the case where the layer of a microcrystal semiconductor or a-SiC: H that does not absorb light in a large quantity or has a wide band gap is deposited, it is preferable that a method be employed which comprises the steps of diluting the raw material gas to 2 to 100 times with a hydrogen gas, and introducing microwave energy or relatively large energy RF power. As an alternative to this, the layer is formed at a relatively high temperature.

In the case where in order to have a desired output voltage and output electric current, the photovoltaic devices are connected in series or in parallel, a protective layer is formed on each of the two sides of the photovoltaic device, and an output taking electrode and the like are mounted. In the case where the photovoltaic devices are connected in series, a backflow-preventive diode is sometimes included.

### Example 1

A photovoltaic device was manufactured by using the deposited film forming apparatus 100 shown in Fig. 1 and in the following procedure.

Initially, an elongated (belt-like) substrate 150 (having a width of 40 cm, length of 200 m and a thickness of 0.125 mm) made of stainless steel (SUS430BA) was sufficiently degreased and cleaned and was set in a continuous sputtering apparatus (not shown). Then, a silver electrode (the purity of silver: 99.99%) was used as a target and a silver thin film having a thickness of 100 nm was deposited by sputtering. Then, a ZnO electrode (the purity of ZnO: 99.999%) was used as a target and a ZnO thin film having a thickness of 1.2 µm was deposited on the silver thin film by sputtering. Thus, a lower electrode was formed on the elongated substrate 150.

Then, a bobbin, around which the elongated substrate 150 was wound, was set in a substrate feeding chamber 102, and the elongated substrate 150 was allowed to pass through the gas gates 151 to 156, n-type layer forming vacuum chamber 103, the MW i-type layer forming vacuum chamber 101, RF i-type layer forming vacuum chambers 104 and 105, and p-type layer forming vacuum chamber 106 to reach the substrate winding chamber 107. Then, the tension was adjusted to prevent slack of the elongated substrate 150. Then, the substrate feeding chamber 102, n-type layer forming vacuum chamber 103, MWi-type layer forming vacuum chamber 101, RFi-type layer forming vacuum chambers 104 and 105, p-type layer forming vacuum chamber 106 and the substrate winding chamber 107 were exhausted to a level of 7 x 10⁻⁴ Pa (5 x 10⁻⁶ Torr) or lower by a vacuum exhausting system (not shown) comprising an oil expanding pump, a mechanical booster pump and a rotary pump.

While operating the vacuum exhausting system, the raw material gas for the deposited film was, under conditions shown in Table 1, introduced into the discharging chamber 113 through the gas introduction pipe 108; the raw material gas for the deposited film was, under conditions shown in Table 2, introduced into the discharging chamber 114 through the gas introduction pipe 109; the raw material gas for the deposited film was, under conditions shown in Table 3, introduced into the discharging chamber 115 through the gas introduction pipe 110; the raw material gas for the deposited film was, under conditions shown in Table 4, introduced into the discharging chamber 116 through the gas introduction pipe 111; and the raw material gas for the deposited film was, under conditions shown in Table 5, introduced into the discharging chamber 117 through the gas introduction pipe 112. Simultaneously, hydrogen gases were, as gate gases, supplied to gas gates 151, 152, 153, 154, 155 and 156 through the corresponding gas gate supply pipes (not shown) at a flow rate of 0.5 standard litres per minute (500 sccm). In the thus-realized state, the exhausting performance of the vacuum exhausting system was adjusted to maintain the internal pressure of the discharging chamber 113 at 7 x 10⁻¹ Pa (5 mTorr) and to maintain that of each of the discharging chambers 114, 115, 116 and 117 at 1.6 x 10² Pa (1.2 Torr).

After the pressure in each of the discharging chambers 113, 114, 115, 116 and 117 had been stabilized, the movement of the elongated substrate 150 from the substrate feeding chamber 102 to the substrate winding chamber 107 was started at a substrate moving speed of 100 cm/minute. While moving the elongated substrate 150, the infrared-ray lamp heaters 118, 119, 120, 121, 122, 123 and 124 were turned on to heat the elongated substrate 150 immediately before entering the inlet of the discharging chamber 113. Cold water was allowed to flow to the cooling roller 125 so that the elongated substrate 150 was cooled immediately after passing the discharging chamber 113.

By adjusting the lamp heaters and the flow rate of the cooling water, the temperature gradients between the thermocouples 126 and 127 and between the thermocouples 128 and 129 were made to be 1°C/s to 50°C/s. The moving speed of the elongated substrate 150 and the length of the discharging chamber in each vacuum chamber were adjusted to make the thickness of the deposited film to be the same, and then the condition was changed within the range shown in Table 8 so as to make the deposition speed to be 5 nm/second, and the temperature of the substrate for the MWi-type layer was set to be higher than that of the RFi-type layer by 50°C.

At this time, the thermocouples 126, 127, 128 and 129 disposed in the vacuum chamber 101 to come in contact with the reverse side of the moving elongated substrate 150 measured the temperatures of the substrate 150 at predetermined positions in the direction in which the substrate 150 was moved. Thus, the moving speed of the elongated substrate 150 was used to obtain the change rate of the substrate temperature per unit time immediately before and immediately after the discharging chamber 113.

Then, the discharge electrodes in the discharging chambers 114, 115, 116 and 117 were supplied with high frequency electric power having a frequency of 13.56 MHz from the high frequency power source so that glow discharge was caused to take place in the discharging chambers 114, 115, 116 and 117. Microwave electric power having a frequency of 2.45 GHz was supplied to each applicator 130 in the discharging chamber 113 through the wave guide pipe 131 from the microwave power source 132 to cause microwave glow discharge to take place in the discharging chamber 113. Thus, semiconductors 403-407 having p-i-n junction as shown in Fig. 8 were formed on the elongated substrate 150 for 10 minutes by sequentially depositing an n-type semiconductor in the n-type layer forming vacuum chamber 103, i-type semiconductors in the i-type layer forming vacuum chambers 104, 101 and 105 and a p-type semiconductor in the p-type layer forming vacuum chamber 106.

After the semiconductors 403 to 407 had been formed on the elongated substrate 150, the elongated substrate 150 was cooled and then it was taken out from the continuous deposited film forming apparatus. A secondary ion mass analyzer (SIMS) (IMS-4F manufactured by CAMECA) was used to examine the diffusion distribution of impurities in the i-type semiconductor in the deposited film.

The results of the examination are shown in Table 6.

As can be understood from the results, by heating and cooling performed at a rate of temperature change of 4°C/second or higher before and after forming the i-type semiconductor layer, the diffusion of impurities into the i-type semiconductor can be prevented.

### Example 2

Similarly to Example 1, a photovoltaic device was manufactured by using the deposited film forming apparatus 200 shown in Fig. 2 and in the following procedure.

Initially, similarly to Example 1, an elongated substrate 250 (having a width of 40 cm, length of 200 m and a thickness of 0.125 mm) made of stainless steel (SUS430BA) was sufficiently degreased and cleaned and was set in a continuous sputtering apparatus (not shown). Then, a silver electrode (the purity of silver: 99.99%) was used as a target and a silver thin film having a thickness of 100 nm was deposited by sputtering. Then, a ZnO electrode (the purity of ZnO: 99.999%) was used as a target and a ZnO thin film having a thickness of 1.2 µm was deposited on the silver thin film by sputtering. Thus, a lower electrode was formed on the elongated substrate 250.

Then, a bobbin, around which the elongated substrate 250 was wound, was set in a substrate feeding chamber 202, and the elongated substrate 250 was allowed to pass through the gas gates 251 to 256, n-type layer forming vacuum chamber 203, the MWi-type layer forming vacuum chamber 201, and the p-type layer forming vacuum chamber 206 to reach the substrate winding chamber 207. Then, the tension was adjusted to prevent slack of the elongated substrate 250. Then, the substrate feeding chamber 202, n-type layer forming vacuum chamber 203, MWi-type layer forming vacuum chamber 201, p-type layer forming vacuum chamber 206 and the substrate winding chamber 207 were exhausted to a level of 7 x 10⁻⁴ Pa (5 x 10⁻⁶ Torr) or lower by a vacuum exhausting system (not shown) comprising an oil expanding pump, a mechanical booster pump and a rotary pump.

While operating the vacuum exhausting system, the raw material gas for the deposited film was, under conditions similar to those shown in Table 1, introduced into the discharging chamber 213 through the gas introduction pipe 208; the raw material gas for the deposited film was, under conditions shown in Table 2, introduced into the discharging chamber 214 through the gas introduction pipe 209; and the raw material gas for the deposited film was, under conditions shown in Table 5, introduced into the discharging chamber 217 through the gas introduction pipe 212. Simultaneously, hydrogen gases were, as gate gases, supplied to gas gates 251, 252, 255 and 256 through the corresponding gas gate supply pipes (not shown) at a flow rate of 0.5 standard litres per minute. In the thus-realized state, the exhausting performance of the vacuum exhausting system was adjusted to maintain the internal pressure of the discharging chamber 213 at 7 x 10⁻¹ Pa (5 mTorr) and to maintain the pressure in each of the discharging chambers 214 and 217 at 1.6 x 10² Pa (1.2 Torr).

After the pressure in each of the discharging chambers 213, 214 and 217 had been stabilized, the movement of the elongated substrate 250 from the substrate feeding chamber 202 to the substrate winding chamber 207 was started at the substrate moving speed of 100 cm/minute. While moving the elongated substrate 250, the infrared-ray lamp heaters 218, 220, 221, 222 and 224 were turned on to heat the elongated substrate 250 immediately before the inlet of the discharging chamber 213. Cold water was allowed to flow to the cooling roller 225 so that the elongated substrate 250 was cooled immediately after passing the discharging chamber 213.

By adjusting the lamp heaters and the flow rate of cooling water similarly to Example 1, the temperature gradients between the thermocouples 226 and 227 and between the thermocouples 228 and 229 were made to be 1°C/s to 50°C/s. The moving speed of the elongated substrate 250 and the length of the discharging chamber in each vacuum chamber were adjusted to make the thickness of the deposited film to be the same, and then the condition was changed within the range shown in Table 8 so as to make the deposition speed to be 5 nm/second, and the temperature of the substrate for the MWi-type layer was set to be higher than that of each of the n-type layer and the p-type layer by 50°C. Thus, the moving speed of the elongated substrate 250 was used to obtain the change rate of the substrate temperature per unit time immediately before and immediately after the discharging chamber 213.

Then, the discharge electrodes in the discharging chambers 214 and 217 were supplied with high frequency electric power having a frequency of 13.56 MHz from the high frequency power source so that glow discharge was caused to take place in the discharging chambers 214 and 217. Microwave electric power having a frequency of 2.45 GHz was supplied to each applicator 230 in the discharging chamber 213 through the wave guide pipe 231 from the microwave power source 232 to cause microwave glow discharge to take place in the discharging chamber 213. Thus, semiconductors 403 to 407 having a p-i-n junction shown in Fig. 9 were formed on the elongated substrate 250 for 10 minutes by sequentially forming an n-type semiconductor in the n-type layer forming vacuum chamber 203, an i-type semiconductor in the MWi-type layer forming vacuum chamber 201, and a p-type semiconductor in the p-type layer forming vacuum chamber 206.

After the semiconductors 403 to 407 had been formed on the elongated substrate 250, the elongated substrate 250 was cooled and then it was taken out from the continuous deposited film forming apparatus. A secondary ion mass analyzer (SIMS) (IMS-4F manufactured by CAMECA) was used to examine the diffusion distribution of impurities in the i-type semiconductor in the deposited film.

The results of the examination are shown in Table 7.

As can be understood from the results, by heating and cooling performed at a rate of temperature change of 4°C/second or higher before and after forming the i-type semiconductor layer, the diffusion of impurities into the i-type semiconductor can be prevented.

### Example 3

Similarly to Example 1, a photovoltaic device was manufactured by using the deposited film forming apparatus 100 shown in Fig. 1 and in the following procedure.

Initially, an elongated substrate 150 (having a width of 40 cm, length of 200 m and a thickness of 0.125 mm) made of stainless steel (SUS430BA) was sufficiently degreased and cleaned and was set in a chambers sputtering apparatus (not shown). Then a silver electrode (the purity of silver: 99.99%) was used as a target and a silver thin film having a thickness of 100 nm was deposited by sputtering. Then, a ZnO electrode (the purity of ZnO: 99.999%) was used as a target and a ZnO thin film having a thickness of 1.2 µm was deposited on the silver thin film by sputtering. Thus, a lower electrode was formed on the elongated substrate 150.

Then, a bobbin, around which the elongated substrate 150 was wound, was set in a substrate feeding chamber 102, and the elongated substrate 150 was allowed to pass through the gas gates 151 to 156, n-type layer forming vacuum chamber 103, the MWi-type layer forming vacuum chamber 101, RFi-layer forming vacuum chambers 104 and 105, and p-type layer forming vacuum chamber 106 to reach the substrate winding chamber 107. Then, the tension was adjusted to prevent slack of the elongated substrate 150. Then, the substrate feeding chamber 102, n-type layer forming vacuum chamber 103, MWi-type layer forming vacuum chamber 101, RFi-type layer forming vacuum chambers 104 and 105, p-type layer forming vacuum chamber 106 and the substrate winding chamber 107 were exhausted to a level of 7 x 10⁻⁴ Pa (5 x 10⁻⁶ Torr) or lower by a vacuum exhausting system (not shown) comprising an oil expanding pump, a mechanical booster pump and a rotary pump.

While operating the vacuum exhausting system, the raw material gas for the deposited film was, under conditions shown in Table 8, introduced into the discharging chamber 113 through the gas introduction pipe 108; the raw material gas for the deposited film was, under conditions shown in Table 2, introduced into the discharging chamber 114 through the gas introduction pipe 109; the raw material gas for the deposited film was, under conditions shown in Table 3, introduced into the discharging chamber 115 through the gas introduction pipe 110; the raw material gas for the deposited film was, under conditions shown in Table 4, introduced into the discharging chamber 116 through the gas introduction pipe 111; and the raw material gas for the deposited film was, under conditions shown in Table 5, introduced into the discharging chamber 117 through the gas introduction pipe 112. Simultaneously, hydrogen gases were, as gate gases, supplied to gas gate 151, 152, 153, 154, 155 and 156 through the corresponding gas gate supply pipes (not shown) at a flow rate of 0.5 standard litres per minute. In the thus-realized state, the performance of the vacuum exhausting system was adjusted to maintain the internal pressure of the discharging chamber 113 at 7 x 10⁻¹ Pa (5 mTorr) and to maintain the pressure in each of the discharging chambers 114, 115, 116 and 117 at 1.6 x 10² Pa (1.2 Torr).

After the pressure in each of the discharging chambers 113, 114, 115 and 116 had been stabilized, the movement of the elongated substrate 150 from the . substrate feeding chamber 102 to the substrate winding chamber 107 was started at the substrate moving speed of 1.67 x 10⁻² m/s (100 cm/minute). While moving the elongated substrate 150, the infrared-ray lamp heaters 118, 119, 120, 121, 122, 123 and 124 were turned on to heat the elongated substrate 150 immediately before entering the inlet of the discharging chamber 113. Cold water was allowed to flow to the cooling roller 125 so that the elongated substrate 150 was cooled immediately after passing the discharging chamber 102.

By setting the substrate temperature of the MWi-type layer to be higher than that of the RFi-type layer by 50°C and by adjusting the lamp heaters and the flow rate of cooling water, the temperature gradients between the thermocouples 126 and 127 and between the thermocouples 128 and 129 were made to be 10°C/s Then, the deposition speed was changed to 0.5 nm/s to 25 nm/s within the condition in the range shown in Table 8. Furthermore, the moving speed of the elongated substrate 150 and the length of the discharging chamber in each vacuum chamber were adjusted to make the thickness of the deposited film to be the same.

Then, the discharge electrodes in the discharging chambers 114, 115, 116 and 117 were supplied with high frequency electric power having a frequency of 13.56 MHz from the high frequency power source so that glow discharge was caused to take place in the discharging chambers 114, 115, 116 and 117. Microwave electric power having a frequency of 2.45 GHz was supplied to each applicator 130 in the discharging chamber 113 through the wave guide pipe 131 from the microwave power source 132 to cause microwave glow discharge to take place in the discharging chamber 113. Thus, semiconductors 403 - 407 having a p-i-n junction as shown in Fig. 6 were formed on the elongated substrate 150 for 10 minutes by sequentially forming an n-type semiconductor in the n-type layer forming vacuum chamber 103, i-type semiconductors in the i-type layer forming vacuum chambers 104, 101 and 105 and a p-type semiconductor in the p-type layer forming vacuum chamber 106.

After the semiconductors 403 to 407 had been formed on the elongated substrate 150, the elongated substrate 150 was cooled and then it was taken out from the continuous deposited film forming apparatus. Furthermore, the transparent electrode 408 and the collecting electrode 409 were formed on the p-type semiconductor 407 to complete formation of an elongated photoelectrical conversion device.

Then, a continuous module forming apparatus (not shown) was used so that the manufactured solar cells were formed into a plurality of solar cell modules each having a size 36 cm x 22 cm. By using pseudo sun light of AM1.5 and 100 mW/cm², the characteristics were evaluated to examine the relationship between the deposition speed of the i-type semiconductor 405 and the characteristics.

The results are shown in Table 9.

As can be understood from the results, by heating and cooling performed at a rate of temperature change of 4°C/second or higher before and after forming the i-type semiconductor layer and raising of the deposition speed to shorten the heating time, the diffusion of impurities into the i-type semiconductor causing deterioration of the characteristics of the solar cell can be prevented. It can be understood that deterioration of the characteristics of the solar cell due to the deterioration in the quality of the i-type semiconductor film can be prevented by preventing the deposition speed from being raised excessively.

### Example 4

Similarly to Example 2, a photovoltaic device was manufactured by using the deposited film forming apparatus 200 shown in Fig. 2 and in the following procedure.

Initially, similarly to Example 1, an elongated substrate 250 (having a width of 40 cm, length of 200 m and a thickness of 0.125 mm) made of stainless steel (SUS430BA) was sufficiently degreased and cleaned and was set in a continuous sputtering apparatus (not shown). Then, a silver electrode (the purity of silver: 99.99%) was used as a target and a silver thin film having a thickness of 100 nm was deposited by sputtering. Then, a ZnO electrode (the purity of ZnO: 99.999%) was used as a target and a ZnO thin film having a thickness of 1.2 µm was deposited on the silver thin film by sputtering. Thus, a lower electrode was formed on the elongated substrate 250.

Then, a bobbin, around which the elongated substrate 250 was wound, was set in a substrate feeding chamber 202, and the elongated substrate 250 was allowed to pass through the gas gates 251 to 256, n-type layer forming vacuum chamber 203, the MWi-type layer forming vacuum chamber 201, and the p-type layer forming vacuum chamber 206 to reach the substrate winding chamber 207. Then, the tension was adjusted to prevent slack of the elongated substrate 250. Then, the substrate feeding chamber 202, n-type layer forming vacuum chamber 203, MWi-type layer forming vacuum chamber 201, p-type layer forming vacuum chamber 206 and the substrate winding chamber 207 were exhausted to a level of 7 x 10⁻⁴ Pa (5 x 10⁻⁶ Torr) or lower by a vacuum exhausting system (not shown) comprising an oil expanding pump, a mechanical booster pump and a rotary pump.

While operating the vacuum exhausting system, the raw material gas for the deposited film was, under conditions similar to those shown in Table 8, introduced into the discharging chamber 213 through the gas introduction pipe 208; the raw material gas for the deposited film was, under conditions shown in Table 2, introduced into the discharging chamber 214 through the gas introduction pipe 209; and the raw material gas for the deposited film was, under conditions shown in Table 5, introduced into the discharging chamber 217 through the gas introduction pipe 212. Simultaneously, hydrogen gases were, as gate gases, supplied to gas gates 251, 252, 255 and 256 through the corresponding gas gate supply pipes (not shown) at a flow rate of 500 sccm. In the thus-realized state, the exhausting performance of the vacuum exhausting system was adjusted to maintain the internal pressure of the discharging chamber 213 at 7 x 10⁻¹ Pa (5 mTorr) and to maintain that in each of the discharging chambers 214 and 217 at 1.6 x 10² Pa (1.2 Torr).

After the pressure in each of the discharging chambers 213, 214 and 217 had been stabilized, the movement of the elongated substrate 250 from the substrate feeding chamber 202 to the substrate winding chamber 207 was started at the substrate moving speed of 1.67 x 10⁻²m/s (100 cm/minute). While moving the elongated substrate 250, the infrared-ray lamp heaters 218, 220, 221, 222 and 224 were turned on to heat the elongated substrate 250 immediately before entering the inlet of the discharging chamber 213. Cold water was allowed to flow to the cooling roller 225 so that the elongated substrate 250 was cooled immediately after passing the discharging chamber 202.

By setting the substrate temperature of the MWi-type layer to be higher than that of the n-type layer and the p-type layer by 50°C and by adjusting the lamp heaters and the flow rate of cooling water similarly to Example 2, the temperature gradients between the thermocouples 226 and 227 and between the thermocouples 228 and 229 were made to be 10°C/s.

The condition was changed within the range shown in Table 8 to change the deposition speed to 0.5 nm/s to 25 nm/s. Furthermore, the moving speed of the elongated substrate 250 and the length of the discharging chamber in each vacuum chamber were adjusted to make the thickness of the deposited film to be the same.

Then, the discharge electrodes in the discharging chambers 214 and 217 were supplied with high frequency electric power having a frequency of 13.56 MHz from the high frequency power source so that glow discharge was caused to take place in the discharging chambers 214 and 217. Microwave electric power having a frequency of 2.45 GHz was supplied to each applicator 230 in the discharging chamber 213 through the wave guide pipe 231 from the microwave power source 232 to cause microwave glow discharge to take place in the discharging chamber 213. Thus, semiconductors 403 to 407 having a p-i-n junction as shown in Fig. 9 were formed on the elongated substrate 250 for 10 minutes by sequentially forming an n-type semiconductor in the n-type layer forming vacuum chamber 203, an i-type semiconductor in the i-type layer forming vacuum chamber 201, and a p-type semiconductor in the p-type layer forming vacuum chamber 206.

After the semiconductors 403 to 407 had been formed on the elongated substrate 250, the elongated substrate 250 was cooled and then it was taken out from the chambers deposited film forming apparatus. Furthermore, the transparent electrode (not shown) and the collecting electrode (not shown) were further formed on the p-type semiconductor 407 so that an elongated photoelectrical conversion device was manufactured.

Then, a continuous module forming apparatus (not shown) was used so that the manufactured solar cells were formed into a plurality of solar cell modules each having a size 36 cm x 22 cm. By using pseudo sunlight of Am1.5 and 100 mW/cm², the characteristics were evaluated to examine the relationship between the deposition speed of the i-type semiconductor 405 and the characteristics.

The results are shown in Table 10.

As can be understood from the results, by heating and cooling performed at a rate of temperature change of 4°C/second or higher before and after forming the i-type semiconductor layer and further raising of the deposition speed to short the heating time, the diffusion of impurities into the i-type semiconductor causing deterioration of the characteristics of the solar cell can be prevented. It can be understood that deterioration of the characteristics of the solar cell due to the deterioration in the quality of the i-type semiconductor film can be prevented by preventing the deposition speed from being raised excessively.

### Example 5

Similarly to Example 3, a photovoltaic device was manufactured by using the deposited film forming apparatus 300 for forming a triple cell shown in Figs. 3, 4 and 5 and in the following procedure.

Similarly to Example 3, an elongated substrate 340 (having a width of 40 cm, length of 200 m and a thickness of 0.125 mm) made of stainless steel (SUS430BA) was sufficiently degreased and cleaned and was set in a continuous sputtering apparatus (not shown). Then, a silver electrode (the purity of silver: 99.99%) was used as a target and a silver thin film having a thickness of 100 nm was deposited by sputtering. Then, a ZnO electrode (the purity of ZnO: 99.999%) was used as a target and a ZnO thin film having a thickness of 1.2 µm was deposited on the silver thin film by sputtering. Thus, a lower electrode was formed on the elongated substrate 340.

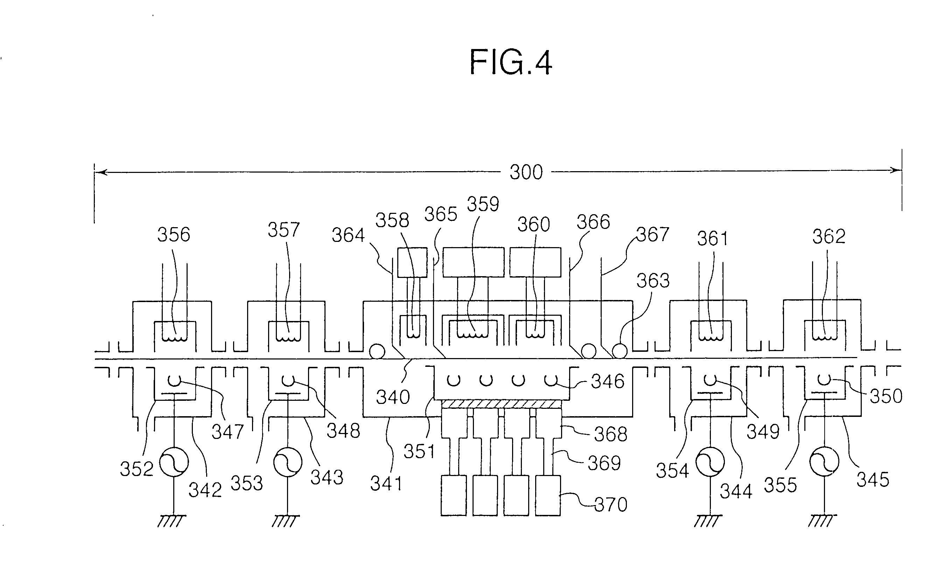

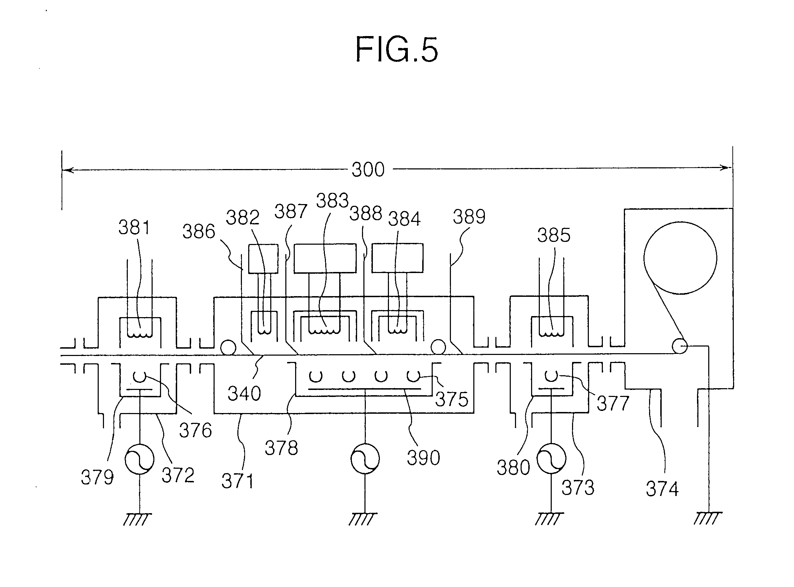

Then, a bobbin, around which the elongated substrate 340 was wound, was set in a substrate feeding chamber 302 shown in Fig. 3, and the elongated substrate 340 was allowed to pass through the introduction side gas gates, n-type layer forming vacuum chamber 303 for the bottom layer, the i-type layer forming vacuum chambers 304, 301 and 305 for the bottom layer, p-type layer forming vacuum chamber 306 for the bottom layer shown in Fig. 3, the n-type layer forming vacuum chamber 342 for the middle layer, the i-type layer forming vacuum chambers 343, 341 and 344 for the middle layer, the p-type layer forming vacuum chamber 345 for the middle layer shown in Fig. 4, the n-type layer forming vacuum chamber 372 for the top layer, the i-type layer forming vacuum chamber 371 for the top layer, the p-type layer forming vacuum chamber 373 for the top layer and the outlet side gas gates shown in Fig. 5 to reach the substrate winding chamber 374. Then, the tension was adjusted to prevent slack of the elongated substrate 340. Then, the substrate feeding chamber 302, the n-type layer forming vacuum chambers 303, 342 and 372, the i-type layer forming vacuum chambers 304, 301, 305, 343, 341, 344 and 371, the p-type layer forming vacuum chambers 306, 345 and 373, and the substrate winding chamber 374 were exhausted to a level of 7 x 10⁻⁴ Pa (5 x 10⁻⁶ Torr) or lower by a vacuum exhausting system (not shown) comprising an oil expanding pump, a mechanical booster pump and a rotary pump.

While operating the vacuum exhausting system, the raw material gas for the deposited film was, similarly to the conditions shown in Table 1, introduced into the discharging chambers 312 and 351 through the gas introduction pipes 307 and 346; the raw material gas for the deposited film was, under conditions shown in Table 2, introduced into the discharging chambers 313,352 and 379 through the gas introduction pipes 308, 347 and 376; the raw material gas for the deposited film was, under conditions shown in Table 3, introduced into the discharging chambers 314, 353 and 378 through the gas introduction pipes 309, 348 and 375; the raw material gas for the deposited film was, under conditions shown in Table 4, introduced into the discharging chambers 315 and 354 through the gas introduction pipes 310 and 349; and the raw material gas for the deposited film was, under conditions shown in Table 5, introduced into the discharging chambers 316, 355 and 380 through the gas introduction pipes 311, 350 and 377. Simultaneously, hydrogen gases were, as gate gases, supplied to the gas gates at a flow rate of 0.5 standard litres per minute (500 sccm) through the gate gas supply pipes (not shown). In the thus-realized state, the exhaustingperformance of the vacuum exhausting system was adjusted to maintain the internal pressure of the discharging chambers 312 and 351 at 7 x 10⁻¹Pa (5 mTorr) and to maintain that in each of the discharging chambers 313, 314, 315, 316, 352, 353, 354, 355, 378, 379 and 380 at 1.6 x 10² Pa (1.2 Torr).

After the pressure in each of the discharging chambers 312, 313, 314, 315, 316, 351, 352, 353, 354, 355, 378, 379 and 380 had been stabilized, the movement of the elongated substrate 340 from the substrate feeding chamber 302 to the substrate winding chamber 374 was started at the substrate moving speed of 100 cm/minute. While moving the elongated substrate 340, the infrared-ray lamp heaters 317, 318, 319, 320, 321, 322, 323, 356, 357, 358, 359, 360, 361, 362, 381, 382, 383, 384 and 385 were turned on to heat the elongated substrate 340 immediately before the inlets of the discharging chambers 312 and 351. Cold water was allowed to flow to the cooling rollers 324 and 363 so that the elongated substrate 340 was cooled immediately after the discharging chambers 312 and 351.

By setting the substrate temperature of the MWi-type layer to be higher than that of the substrate temperature of the RFi-type layer by 50°C and by adjusting the lamp heater and the flow rate of cooling water, the temperature gradients between the thermocouples 325 and 326, between the thermocouples 364 and 365, between the thermocouples 327 and 328 and between the thermocouples 366 and 367 were made to be 4°C/second or more. The moving speed of the elongated substrate 340 and the length of the discharging chamber in each vacuum chamber were adjusted to make the deposition speed of the i-type layer semiconductor to be 10 nm/second.

To make photoelectric currents generated by respective cells 411, 412 and 413 to be smaller in the mentioned order of the cells 411, 412 and 413 when light is made incident upon the photovoltaic device shown in Fig. 10, the lengths of the discharging chambers 312, 351 and 378 were adjusted.

At this time, the thermocouples 325, 326, 364, 365, 327, 328, 366 and 367 disposed in the vacuum chambers 301 and 341 to come in contact with the reverse side of the moving elongated substrate 340 measured the temperatures of the substrate 340 at predetermined positions in the direction in which the substrate 340 was moved. Thus, the moving speed of the elongated substrate 340 was used to obtain the change rate of the substrate temperature per unit time immediately before and immediately after the discharging chambers 312 and 351.

Then, the discharge electrodes in the discharging chambers 313, 314, 315, 316, 352, 353, 354, 355, 378, 379 and 380 were supplied with high frequency electric power having a frequency of 13.56 MHz from the high frequency power source so that glow discharge was caused to take place in the discharging chambers 313, 314, 315, 316, 352, 353, 354, 355, 378, 379 and 380. Microwave electric power having a frequency of 2.45 GHz was supplied to applicators 329 and 368 in the discharging chambers 312 and 351 through the wave guide pipes 330 and 369 from the microwave power sources 331 and 370 to cause microwave glow discharge to take place in the discharging chambers 312 and 351. Thus, semiconductors 403-407 having p-i-n junctions as shown in Fig. 10 were formed on the elongated substrate 340 for 10 minutes by sequentially forming the n-type semiconductors in the n-type layer forming vacuum chambers 303, 340 and 372, the i-type semiconductors in the i-type layer forming vacuum chambers 301, 304, 305, 341, 343, 344 and 371, and the p-type semiconductors in the p-type layer forming vacuum chambers 306, 345 and 373.

After the semiconductors 403 to 407 had been formed on the elongated substrate 340, the elongated substrate 340 was cooled and then it was taken out from the continuous deposited film forming apparatus. Furthermore, the transparent electrode 408 and the collecting electrode 409 were formed on the p-type semiconductor so that the solar cell which was an elongated photoelectrical conversion device was manufactured.

Then, a continuous module forming apparatus (not shown) was used so that the manufactured solar cells were formed into a plurality of solar cell modules each having a size 36 cm x 22 cm. By using pseudo sun light of AM1.5 and 100 mW/cm², the characteristics were evaluated to examine the relationship between the change rate of the substrate temperature and the characteristics immediately before and immediately after the discharging chambers 312 and 351.

The results are shown in Table 11.

As can be understood from the results, by heating and cooling performed at a rate of temperature change of 4°C/second or higher before and after forming the i-type semiconductor layer, the diffusion of impurities into the i-type semiconductor can be prevented. As the result, excellent characteristics of the solar cell were obtained.

### Example 6

Similarly to Example 4, a photovoltaic device was manufactured by using the deposited film forming apparatus 200 shown in Fig. 2 and in the following procedure.

Initially, similarly to Example 1, an elongated substrate 250 (having a width of 40 cm, length of 200 m and a thickness of 0.125 mm) made of stainless steel (SUS430BA) was sufficiently degreased and cleaned and was set in a continuous sputtering apparatus (not shown). Then, a silver electrode (the purity of silver: 99.99%) was used as a target and a silver thin film having a thickness of 100 nm was deposited by sputtering. Then, a ZnO electrode (the purity of ZnO: 99.999%) was used as a target and a ZnO thin film having a thickness of 1.2 µm was deposited on the silver thin film by sputtering. Thus, a lower electrode was formed on the elongated substrate 250.

Then, a bobbin, around which the elongated substrate 250 was wound, was set in a substrate feeding chamber 202, and the elongated substrate 250 was allowed to pass through the gas gates 251 to 256, n-type layer forming vacuum chamber 203, the MWi-type layer forming vacuum chamber 201, and the p-type layer forming vacuum chamber 206 to reach the substrate winding chamber 207. Then, the tension was adjusted to prevent slack of the elongated substrate 250. Then, the substrate feeding chamber 202, n-type layer forming vacuum chamber 203, i-type layer forming vacuum chamber 201, p-type layer forming vacuum chamber 206 and the substrate winding chamber 207 were exhausted to a level of 7 x 10⁻⁴ Pa (5 x 10⁻⁶ Torr) or lower by a vacuum exhausting system (not shown) comprising an oil expanding pump, mechanical booster pump and a rotary pump.

While operating the vacuum exhausting system, the raw material gas for the deposited film was, under conditions shown in Table 8, introduced into the discharging chamber 213 through the gas introduction pipe 208; the raw material gas for the deposited film was, under conditions shown in Table 2, introduced into the discharging chamber 214 through the gas introduction pipe 209; and the raw material gas for the deposited film was, under conditions shown in Table 5, introduced into the discharging chamber 217 through the gas introduction pipe 212. Simultaneously, hydrogen gases were, as gate gases, supplied to gas gates 251, 252, 255 and 256 through the corresponding gas gate supply pipes (not shown) at a flow rate of 0.5 standard litres per minute. In the thus-realized state, the exhausting perforance of the vacuum exhausting system was adjusted to maintain the pressure in the discharging chamber 213 at 7 x 10⁻¹Pa (5 mTorr) and to maintain that in each of the discharging chambers 214 and 217 at 1.6 x 10² Pa (1.2 Torr).

After the pressure in each of the discharging chambers 213, 214, 216 and 217 had been stabilized, the movement of the elongated substrate 250 from the substrate feeding chamber 202 to the substrate winding chamber 207 was started at the substrate moving speed of 1.67 x 10⁻² m/s (100 cm/minute). While moving the elongated substrate 250, the infrared-ray lamp heaters 218, 220, 221, 222 and 224 were turned on to heat the elongated substrate 250 immediately before the inlet of the discharging chamber 213. Cold water was allowed to flow to the cooling roller 225 so that the elongated substrate 250 was cooled immediately after the discharging chamber 202.

By adjusting the lamp heaters and the flow rate of cooling water similarly to Example 2, the temperature gradients between the thermocouples 226 and 227 and between the thermocouples 228 and 229 were made to be 10 degree/second. The substrate temperature of the i-type semiconductor was made to be higher. The difference between the substrate temperatures of the n-type semiconductor and of the i-type semiconductor and between the substrate temperatures of the i-type semiconductor and of the p-type semiconductor were in the range 5°C to 400°C. By changing the condition within the range shown in Fig. 8, the deposition speed was made to be 5 nm/second. Furthermore, the moving speed of the elongated substrate 250 and the length of the discharging chamber in each vacuum chamber were adjusted to make the thickness of the deposited film to be the same.

Then, the discharge electrodes in the discharging chambers 214 and 217 were supplied with high frequency electric power having a frequency of 13.56 MHz from the high frequency power source so that glow discharge was caused to take place in the discharging chambers 214 and 217. Microwave electric power having a frequency of 2.45 GHz was supplied to each applicator 230 in the discharging chamber 213 through the wave guide pipe 231 from the microwave power source 232 to cause microwave glow discharge to take place in the discharging chamber 213. Thus, semiconductors were 403 to 407 having p-i-n junctions shown in Fig. 9 were formed on the elongated substrate 250 for 10 minutes by sequentially forming an n-type semiconductor in the n-type layer forming vacuum chamber 203, an i-type semiconductor in the i-type layer forming vacuum chamber 201, and a p-type semiconductor in the p-type layer forming vacuum chamber 206.

After the semiconductors 403 to 407 had been formed on the elongated substrate 250, the elongated substrate 250 was cooled and then it was taken out from the continuous deposited film forming apparatus. Furthermore, the transparent electrode (not shown) and the collecting electrode (not shown) were formed on the p-type semiconductor 407 so that an elongated solar cell was manufactured.

Then, a continuous module forming apparatus (not shown) was used so that the manufactured solar cells were formed into a multiplicity of solar cell modules each having a size 36 cm x 22 cm. By using pseudo sun light of AM1.5 and 100 mW/cm², the characteristics were evaluated to examine the relationship between the deposition speed and the characteristics of the i-type semiconductor 405.

The results are shown in Table 12.

As can be understood from the results, by heating and cooling performed at a rate of temperature change of 4°C/second or higher before and after forming the i-type semiconductor layer and by setting the difference between the substrate temperature before and after the forming at 10°C or more, doping of phosphorus atoms into the n-layer and boron atoms in the p-layer can be performed efficiently- If the difference is 300°C or more, diffusion of phosphorous in the n-layer and boron atoms in the p-layer into the i-layer cannot be prevented. In this case, the characteristics of the solar cell deteriorates.

### Comparative Example 1

Similarly to Example 5, a photovoltaic device was manufactured by using the deposited film forming apparatus 300 shown in Figs. 3, 4 and 5 and in the following procedure.

A silver thin film and a ZnO thin film were formed on the elongated substrate 340 made of stainless steel (SUS430BA) similarly to Example 3 so that a lower electrode was formed.

Then, a bobbin, around which the elongated substrate 340 was wound, was set in a substrate feeding chamber 302, and the elongated substrate 340 was, similarly to Example 5, passed through to the substrate winding chamber 374. Then, the tension was adjusted to prevent slack of the elongated substrate 340. Then, the substrate feeding chamber 302, the n-type layer forming vacuum chambers 303, 342 and 372, the i-type layer forming vacuum chambers 304, 301, 305, 343, 341, 344 and 371, the p-type layer forming vacuum chambers 306, 345 and 373, and the substrate winding chamber 374 were exhausted to a level of 7 x 10⁻⁴ Pa (5 x 10⁻⁶ Torr) or lower by a vacuum exhausting system (not shown) comprising an oil expanding pump, a mechanical booster pump and a rotary pump.

While operating the vacuum exhausting system, and similarly to Example 5, the raw material gas for the deposited film was, under the same conditions shown in Table 1, introduced into the discharging chambers 312 and 351 through the gas introduction pipes 307 and 346; the raw material gas for the deposited film was, under conditions shown in Table 2, introduced into the discharging chambers 313, 352 and 379 through the gas introduction pipes 308, 347 and 376; the raw material gas for the deposited film was, under conditions shown in Table 3, introduced into the discharging chambers 314, 353 and 378 through the gas introduction pipes 309, 348 and 375; the raw material gas for the deposited film was, under conditions shown in Table 4, introduced into the discharging chambers 315 and 354 through the gas introduction pipes 310 and 349; and the raw material gas for the deposited film was, under conditions shown in Table 5, introduced into the discharging chambers 316, 355 and 380 through the gas introduction pipes 311, 350 and 377. Simultaneously, hydrogen gases were, as gate gases, supplied to the gas gates at a flow rate of 0.5 standard litres per minute through the gate gas supply pipes (not shown). In the thus-realized state, the exhausting performance of the vacuum exhausting system was adjusted to maintain the pressure in the discharging chambers 312 and 351 at 0,7 Pa (5 mTorr) and to maintain that in each of the discharging chambers 313, 314, 315, 316, 352, 353, 354, 355, 378, 379 and 380 at 160Pa (1.2 Torr).

After the pressure in each of the discharging chambers 312, 313, 314, 315, 316, 351, 352, 353, 354, 355, 378, 379 and 380 had been stabilized, the movement of the elongated substrate 340 was started at a moving speed of 1.67 x 10⁻² m/s (100 cm/minute). Then, the infrared-ray lamp heaters were turned on to heat the elongated substrate 340 immediately before the inlets of the discharging chambers 312 and 351. Cold water was allowed to flow to the cooling rollers 324 and 363 so that the elongated substrate 340 was cooled immediately after the discharging chambers 312 and 351.

By adjusting the lamp heaters and the flow rate of cooling water, the temperature gradient among the thermocouples 325, 326, 364 and 365 and among the thermocouples 327, 328, 366 and 367 was made to be 4°C/second or less. To make the deposition speed of the i-type semiconductor to be 10 nm/sec, the moving speed of the elongated substrate 340 and the length of the discharging chamber in each vacuum chamber were adjusted.

To make photoelectric currents generated by respective cells 411, 412 and 413 to be smaller in the sequential order as those generated in the cells 411, 412 and 413 when light is made incident upon the photovoltaic device shown in Fig. 10, the lengths of the discharging chambers 312, 351 and 378 were adjusted.

At this time, the thermocouples 325, 326, 364, 365, 327, 328, 366 and 367 disposed in the vacuum chambers 301 and 341 to come in contact with the reverse side of the moving elongated substrate 340 measured the temperatures of the substrate 340 at predetermined positions in the direction in which the substrate 340 was moved. Thus, the moving speed of the elongated substrate 340 was used to obtain the change rate of the substrate temperature per unit time immediately before and immediately after the discharging chambers 312 and 351.

Then, similarly to Example 5, high frequency electric power having a frequency of 13.56 MHz was supplied from the high frequency power source so that glow discharge was caused to take place in the discharging chambers 313, 314, 315, 316, 352, 353, 354, 355, 378, 379 and 380. Microwave electric power having a frequency of 2.45 GHz was supplied to applicators through the wave guide pipes from the microwave power sources to cause microwave glow discharge to take place in the discharging chambers 312 and 351.

The semiconductors 420 to 442 having p-i-n junctions shown in Fig. 10 were formed on the elongated substrate 340 for 10 minutes.

After the semiconductors 420 to 442 had been formed on the elongated substrate 340, the elongated substrate 340 was cooled and then it was ejected from the continuous deposited film forming apparatus. Furthermore, the transparent electrode 408 and the collecting electrode 409 were formed on the p-type semiconductor 407 so that an elongated solar cell was manufactured.

Then, similarly to Example 5, a continuous module forming apparatus (not shown) was used so that the manufactured solar cells were formed into solar cell modules. By using pseudo sun light of AM1.5 and 100 mW/cm², the characteristics were evaluated to examine the relationship between the change rate of the substrate temperature per unit time and the characteristics immediately before and immediately after the discharging chambers 312 and 351.

The results are shown in Tables 13 and 14.

As can be understood from the results, heating and cooling performed at a rate of the temperature change of not higher than 4°C/second before and after forming the i-type semiconductor layer resulted in the diffusion of impurities into the i-type semiconductor. In this case, excellent characteristics of the solar cell cannot be obtained.

As described above, according to the present invention, there is provided a process for forming a deposited film by plasma CVD so as to continuously form a deposited film on an elongated substrate in a vacuum chamber, which comprises heating the substrate immediately before an inlet of a flow discharging region in the vacuum chamber at a rate of 4°C/second or higher and while cooling said substrate at a rate of 4°C/second or higher immediately after an outlet of the glow discharging region while continuously moving the substrate in a lengthwise direction of the substrate in the vacuum chamber and forming a semiconductor layer on the substrate at a deposition speed of 0.1 nm/second to 20 nm/second by plasma CVD. As a result, the semiconductor can be protected from annealing, a solar cell exhibiting excellent conversion efficiency can be formed continuously on a substrate having a larger area without non-uniformity.

**Table 1**

| | |
|---|---|
| Raw Material Gas | SiH₄: 0.5 standard litres per minute |
| | GeH₄: 0.2 standard litres per minute |
| | H² : 0.8 standard litres per minute |
| Microwave Electric power | 500 W |
| Position at which the temperature of substrate is measured at the time of moving the substrate | Thermocouple 126 (in the vicinity of the inlet of discharging chamber) |
| | Thermocouple 127 (immediately before the discharging chamber) |
| | Thermocouple 128 (immediately after the discharging chamber) |
| | Thermocouple 129 (in the vicinity of the outlet of the electricity discharge chamber) |

**Table 2**

| | |
|---|---|
| Raw material gas | SiH₄: 0.2 standard litres per minute |
| | H₂ : 0.4 standard litres per minute |
| High frequency Electric power | 400 W |
| Substrate Temperature in Discharging Chamber | 300°C (constant) |
| Pressure in Discharging Chamber in Discharging | 1.5x10² Pa (1.1 Torr) |

**Table 3**

| | |
|---|---|
| Raw material gas | SiH₄: 0.2 standard litres per minute |
| | H₂ : 0.4 standard litres per minute |
| High frequency Electric power | 400 W |
| Substrate Temperature in Discharging Chamber | 300°C (constant) |
| Pressure in Discharging Chamber | 1.5x10² Pa (1.1 Torr) |

**Table 4**

| | |
|---|---|
| Raw material gas | SiH₄: 0.2 standard litres per minute |
| | H₂ : 0.4 standard litres per minute |
| High frequency Electric power | 400 W |
| Substrate Temperature in Discharging Chamber | 300°C (constant) |
| Pressure in Discharging Chamber | 1.5x10² Pa (1.1 Torr) |

**Table 5**

| | |
|---|---|
| Raw material gas | SiH₄:0.025 standard litres per min. |
| | BF₃ :0.001 standard litres per min. |
| | H₂ :0.9 standard litres per minute |
| High frequency Electric power | 700 W |
| Substrate Temperature in Discharging Chamber | 220°C (constant) |
| Pressure in Discharging Chamber | 1.5x10² Pa (1.1 Torr) |

**Table 6**

| | | | | | | | | | |
|---|---|---|---|---|---|---|---|---|---|
| | *1 | | | | | | | | |
| *2 | | 1.0 | 2.0 | 3.0 | 4.0 | 5.0 | 10.0 | 20.0 | 50.0 |
| | 1.0 | D | D | D | D | D | D | D | D |
| | 2.0 | D | D | D | D | C | C | C | C |
| | 3.0 | D | D | C | B | B | B | B | B |
| | 4.0 | D | D | C | A | A | A | A | A |
| | 5.0 | D | B | B | A | A | A | A | A |
| | 10.0 | D | C | B | A | A | A | A | A |
| | 20.0 | D | C | B | A | A | A | A | A |
| | 50.0 | D | B | B | A | A | A | A | A |

| | | | | | | | | | |
|---|---|---|---|---|---|---|---|---|---|
| *1 Temperature gradient from RFi-type semiconductor 404 to MWi-type semiconductor 405 (°C/second) *2 Temperature gradient from MWi-type semiconductor 405 to RFi-type semiconductor 406 (°C/second) | | | | | | | | | |

As for the half value (film thickness) of the content of dopant in a doped layer (sandwiching the Mwi-layer) evaluated with SIMS, assuming the point of *1: 50°C/sec and *2: 50°C/sec to be 1, results of 0.9 or higher were given A, results of 0.8 or higher and not higher than 0.9 were given B, results of 0.05 or higher and not higher than 0.8 were given C, and results not higher than 0.5 were given D.

**Table 7**

| | | | | | | | | | |
|---|---|---|---|---|---|---|---|---|---|
| | *3 | | | | | | | | |
| *4 | | 1.0 | 2.0 | 3.0 | 4.0 | 5.0 | 10.0 | 20.0 | 50.0 |
| | 1.0 | D | D | D | D | D | D | D | D |
| | 2.0 | D | D | D | D | D | D | D | C |
| | 3.0 | D | D | D | C | C | B | B | B |
| | 4.0 | D | D | C | A | A | A | A | A |
| | 5.0 | D | D | C | A | A | A | A | A |
| | 10.0 | D | D | C | A | A | A | A | A |
| | 20.0 | D | D | B | A | A | A | A | A |
| | 50.0 | D | D | B | A | A | A | A | A |

| | | | | | | | | | |
|---|---|---|---|---|---|---|---|---|---|
| *3 Temperature gradient from n-type semiconductor 403 to MWi-type semiconductor 405 (°C/second) *4 Temperature gradient from MWi-type semiconductor 405 to p-type semiconductor 407 (°C/second) | | | | | | | | | |

As for the half value (film thickness) of the content of dopant in a doped layer (sandwiching the MWi-layer) evaluated with SIMS, assuming the point of *3: 50°C/sec and *4: 50°C/sec to be 1, results of 0.9 or higher were given A, results of 0.8 or higher and not higher than 0.9 were given B, results of 0.05 or higher and not higher than 0.8 were given C, and results not higher than 0.5 were given D.

**Table 8**

| | |
|---|---|
| Raw Material Gas | SiH₄ 0.05 to 0.5 standard litres per minute |
| | GeH₄ 0.02 to 0.2 standard litres per minute |
| | H₂ 0.3 to 0.8 standard litres per minute |
| Microwave Electric | 300 to 500 W |
| Power | |

**Table 9**

| Deposition Rate of i-type Semiconductor (nm/sec) | Characteristics |
|---|---|
| 0.5 | D |
| 0.8 | C |
| 1.0 | A |
| 5.0 | A |
| 20.0 | A |
| 22.0 | C |
| 25.0 | D |

where assuming that the characteristics at deposition rate of 20.0 nm/sec (practically acceptable limit of characteristics having Isc, Voc and F.F. that are not too low) to be 1, results of 1 or higher were given A, results not higher than 1 and 0.7 or higher were given B, results not higher than 0.7 were given C and results of 0.5 or lower were given D.

**Table 10**

| Deposition Rate of i-type Semiconductor (nm/sec) | Characteristics |
|---|---|
| 0.5 | D |
| 0.8 | B |
| 1.0 | A |
| 5.0 | A |
| 20.0 | A |
| 22.0 | D |
| 25.0 | D |

where assuming that the characteristics at deposition rate of 20.0 nm/sec (practically acceptable limit of characteristics) to be 1, results of 1 or higher were given A, results not higher than 1 and 0.7 or higher were given B, results not higher than 0.7 were given C and results of 0.5 or lower were given D.

**Table 11**

| | | | | | | |
|---|---|---|---|---|---|---|
| *1 | | | | | | |
| *2 | | 4.0 | 5.0 | 10.0 | 20.0 | 50.0 |
| | 4.0 | A | A | A | A | A |
| | 5.0 | A | A | A | A | A |
| | 10.0 | A | A | A | A | A |
| | 20.0 | A | A | A | A | A |
| | 50.0 | A | A | A | A | A |

| | | | | | | |
|---|---|---|---|---|---|---|
| *1 Temperature gradient from RFi-type semiconductor 404 to MWi-type semiconductor 405 (°C/second) *2 Temperature gradient from MWi-type semiconductor 405 to RFi-type semiconductor 406 (°C/second) | | | | | | |

where assuming that the characteristics at a change rate of the substrate temperature of 4.0 (°C/sec)/4.0 (°C/sec) (practically acceptable limit of characteristics) to be 1, results of 1 or higher were given A.

**Table 12**

| | | | | | | | | | |
|---|---|---|---|---|---|---|---|---|---|
| | *3 | | | | | | | | |
| *4 | | 5 | 10 | 20 | 50 | 100 | 200 | 300 | 350 |
| | 5 | C | C | C | C | C | C | C | D |
| | 10 | B | A | A | A | A | A | A | D |
| | 20 | B | A | A | A | A | A | A | D |
| | 50 | B | A | A | A | A | A | A | D |
| | 100 | B | A | A | A | A | A | A | D |
| | 200 | B | A | A | A | A | A | A | D |
| | 300 | B | A | A | A | A | A | A | D |
| | 350 | D | D | D | D | D | D | D | D |

| | | | | | | | | | |
|---|---|---|---|---|---|---|---|---|---|
| *3 Temperature gradient from n-type semiconductor 403 to MWi-type semiconductor 405 (°C/second) *4 Temperature gradient from MWi-type semiconductor 405 to p-type semiconductor 407 (°C/second) | | | | | | | | | |

where assuming that the characteristics at the change of the substrate temperature was 10 (°C/sec)/10 (°C/sec) (practically acceptable limit of characteristics) to be 1, results of 1 or higher were given A, results not higher than 1 and 0.7 or higher were given B, results not higher than 0.7 were given C and results not higher than 0.5 were given D.

**Table 13**

| | | | | | | | | | |
|---|---|---|---|---|---|---|---|---|---|
| | *1 | | | | | | | | |
| *2 | | 1.0 | 2.0 | 3.0 | 4.0 | 5.0 | 10.0 | 20.0 | 50.0 |
| | 1.0 | D | D | D | D | D | D | D | D |
| | 2.0 | D | D | D | D | D | D | D | D |
| | 3.0 | D | D | D- | D | D | C | C | C |

| | | | | | | | | | |
|---|---|---|---|---|---|---|---|---|---|
| *1 Temperature gradient from RFi-type semiconductor 404 to MWi-type semiconductor 405 (°C/second) *2 Temperature gradient from MWi-type semiconductor 405 to RFi-type semiconductor 406 (°C/second) | | | | | | | | | |

where assuming that the characteristics at the change rate of substrate temperature of 4.0 (°C/sec)/4.0 (°C/sec) (practically acceptable limit of characteristics) to be 1, results not higher than 0.7 and 0.5 or higher were given C and results not higher than 0.5 were given D.

**Table 14**

| | | | | | | | | | |
|---|---|---|---|---|---|---|---|---|---|
| | *1 | | | | | | | | |
| *2 | | 1.0 | 2.0 | 3.0 | 4.0 | 5.0 | 10.0 | 20.0 | 50.0 |
| | 1.0 | D | D | D | D | D | D | D | D |
| | 2.0 | D | D | D | D | D | D | D | D |
| | 3.0 | D | D | D | D | C | C | C | C |

| | | | | | | | | | |
|---|---|---|---|---|---|---|---|---|---|
| *1 Temperature gradient from RFi-type semiconductor 404 to MWi-type semiconductor 405 (°C/second) *2 Temperature gradient from MWi-type semiconductor 405 to RFi-type semiconductor 406 (°C/second) | | | | | | | | | |

where assuming that the characteristics at the change rate of substrate temperature of 4.0 (°C/sec)/4.0 (°C/sec) (practically acceptable limit of characteristics) to be 1, results not higher than 0.7 and 0.5 or higher were given C and results not higher than 0.5 were given D.

## Claims

1. A method of forming a deposited semiconductor film which is performed by steps of:
supplying a substrate having thereon a film of p-type or n-type conductivity semiconductor formed of an amorphous, microcrystalline or polycrystalline semiconductor material formed of a group IV element or group IV type alloy;
forming, by glow discharge, on said film of p-type or n-type conductivity semiconductor, a film of i-type conductivity semiconductor formed of an amorphous or microcrystalline semiconductor material formed of a group IV element or group IV type alloy; and;
forming a semiconductor film of n-type or p-type conductivity, respectively, so as to produce a pin or nip junction;
**characterised by**:
a step of rapid heating, which is performed immediately prior to performing said step of forming the film of i-type conductivity semiconductor, by which the temperature of the substrate is raised by 10°C to 300°C, at a rate of 4°C/s or higher; and
a step of rapid cooling the substrate, which is performed immediately following said step of forming the film of i-type conductivity semiconductor, whereby the substrate is cooled by 10°C to 300°C at a rate of 4°C/s or higher;
wherein:
said film of i-type conductivity semiconductor is formed on said film of p-type or n-type conductivity semiconductor at a deposition rate of between 0.1nm/second and 20nm/second and at a temperature of 100°C to 450°C; and
said step of forming a semiconductor film of n-type or p-type conductivity to produce a pin or nip junction is performed after said step of rapid cooling has been completed.

2. A method according to claim 1, wherein the substrate is cooled by flowing a cooling medium.

3. A method according to claim 1 or 2, wherein each of the steps of rapid heating, of forming by glow discharge, and of rapid cooling is performed in one and the same vacuum chamber.

4. A method according to any preceding claim, further comprising a step of maintaining the temperature of the substrate while the step of forming by glow discharge is performed.

5. A method according to any preceding claim, wherein, in the step of supplying the substrate, the film of p-type or n-type conductivity semiconductor is formed by a plasma CVD method.

6. A method according to claim 5, wherein the plasma CVD method is a high frequency plasma CVD method.

7. A method according to any preceding claim, wherein the glow discharge is caused by a microwave plasma CVD method.

8. A method according to any preceding claim wherein the substrate has a belt-like form and the substrate is moved continuously in the lengthwise direction while the method is performed.

9. A method according to claim 8 depending from claim 3 wherein the continuously moving substrate is rapidly heated as aforesaid immediately before an inlet of the glow discharging region in said vacuum chamber, and the continuously moving substrate is rapidly cooled as aforesaid immediately after an outlet of said glow discharging region.

## Patentansprüche

1. Verfahren zum Bilden eines abgeschiedenen Halbleiterfilms, welches durch die Schritte ausgeführt wird:
Bereitstellen eines Trägermaterials mit einem Film eines p-leitfähigen oder eines n-leitfähigen Halbleiters darauf, der aus einem amorphen, mikrokristallinen oder polykristallinen Halbleitermaterial gebildet wird, das aus einem Element der Gruppe IV oder einer Legierung aus der Gruppe IV gebildet wird;
Bilden eines Films aus einem i-leitfähigen Halbleiter, der aus einem amorphen oder mikrokristallinen Halbleitermaterial gebildet wird, das aus einem Element der Gruppe IV oder einer Legierung aus der Gruppe IV gebildet wird, durch Glimmentladung auf dem Film des p-leitfähigen oder des n-leitfähigen Halbleiters; und
Bilden eines Halbleiterfilms mit jeweils n-Leitfähigkeit oder p-Leitfähigkeit, so dass ein p-i-n oder ein n-i-p Übergang hergestellt wird;
**gekennzeichnet durch**:
einen Schritt des schnellen Aufheizens, welcher unmittelbar vor dem Durchführen des Schrittes des Bildens des Films aus einem i-leitfähigen Halbleiter ausgeführt wird, wodurch die Temperatur des Trägermaterials von 10 °C auf 300 °C mit einer Rate von 4°C/s oder höher angehoben wird; und
einen Schritt des schnellen Abkühlens des Trägermaterials, welcher unmittelbar nachfolgend zu dem Schritt des Bildens des Films aus einem i-leitfähigen Halbleiter ausgeführt wird, wodurch das Substrat von 10°C auf 300°C mit einer Rate von 4°C/s oder höher gekühlt wird;
wobei der Film aus einem i-leitfähigen Halbleiter auf dem Film aus einem p-leitfähigen oder einem n-leitfähigen Halbleiter mit einer Abscheidungsrate zwischen 0,1 nm / Sekunde und 20 nm / Sekunde und bei einer Temperatur von 100 °C bis 450 °C gebildet wird; und
wobei der Schritt des Bildens eines Halbleiterfilms aus einem n-leitfähigen oder einem p-leitfähigen Material, um einen p-i-n oder einen n-i-p Übergang herzustellen, ausgeführt wird, nachdem der Schritt des schnellen Abkühlens abgeschlossen wurde.

2. Das Verfahren nach Anspruch 1, wobei das Trägermaterial durch Fließen eines Kühlmediums gekühlt wird.

3. Das Verfahren nach Anspruch 1 oder 2, wobei jeder der Schritte des schnellen Aufheizens, des Bildens durch Glimmentladung und des schnellen Abkühlens in ein und derselben Vakuumkammer ausgeführt wird.

4. Das Verfahren nach einem der vorhergehenden Ansprüche, welches ferner einen Schritt des Aufrechterhaltens der Temperatur des Substrats umfasst, während der Schritt des Bildens durch Glimmentladung ausgeführt wird.

5. Verfahren nach einem der vorhergehenden Ansprüche, wobei in dem Schritt des Bereitstellens des Trägermaterials der Film auseinem p-leitfähigen oder einem n-leitfähigen Halbleiter durch ein Plasma-CVD-Verfahren gebildet wird.

6. Verfahren nach Anspruch 5, wobei das Plasma-CVD-Verfahren ein Hochfrequenz-Plasma-CVD-Verfahren ist.

7. Verfahren nach einem der vorhergehenden Ansprüche, wobei die Glimmentladung durch ein Mikrowellen-Plasma-CVD-Verfahren hervorgerufen wird.

8. Verfahren nach einem der vorhergehenden Ansprüche, wobei das Trägermaterial eine bandähnliche Form aufweist, und wobei das Trägermaterial kontinuierlich in der Längenrichtung bewegt wird, während das Verfahren ausgeführt wird.

9. Verfahren nach Anspruch 8, abhängig von Anspruch 3, wobei das sich kontinuierlich bewegende Substrat, wie vorstehend erwähnt, unmittelbar vor einem Einlass des Glimmentladungsbereiches in der Vakuumkammer schnell aufgeheizt wird, und wobei das sich kontinuierlich bewegende Trägermaterial, wie vorstehend erwähnt, unmittelbar nach einem Auslass aus dem Glimmentladungsbereich schnell abgekühlt wird.

## Revendications

1. Procédé de formation d'un film de semi-conducteur déposé qui est exécuté par les étapes qui consistent :
à fournir un substrat portant un film d'un semi-conducteur de conductivité de type p ou de type n formé d'une matière semi-conductrice amorphe, microcristalline ou polycristalline constituée d'un élément du groupe IV ou d'un alliage du type du groupe IV ;
à former, par décharge luminescente, sur ledit film de semi-conducteur de conductivité de type p ou de type n, un film d'un semi-conducteur de conductivité de type i formé d'une matière semi-conductrice amorphe ou microcristalline constituée d'un élément de groupe IV ou d'un alliage du type du groupe IV ; et
à former un film de semi-conducteur de conductivité de type n ou de type p, respectivement, afin de produire une jonction pin ou nip ;
**caractérisé par** :
une étape de chauffage rapide, qui est exécutée immédiatement avant l'exécution de ladite étape de formation du film de semi-conducteur de conductivité de type i, par laquelle la température du substrat est élevée d'une valeur comprise entre 10°C et 300°C, à une vitesse de 4°C/s ou plus ; et
une étape de refroidissement rapide du substrat, qui est effectuée immédiatement à la suite de ladite étape de formation du film de semi-conducteur de conductivité de type i, par laquelle le substrat est refroidi d'une valeur comprise entre 10°C et 300°C, à une vitesse de 4°C/s ou plus;
dans lequel:
ledit film de semi-conducteur de conductivité de type i est formé sur ledit film de semi-conducteur de conductivité de type p ou de type n à une vitesse de dépôt comprise entre 0,1 nm/s et 20 nm/s et à une température de 100°C à 450°C ; et
ladite étape de formation d'un film de semi-conducteur de conductivité de type n ou de type p pour produire une jonction pin ou nip est effectuée après l'achèvement de ladite étape de refroidissement rapide.

2. Procédé selon la revendication 1, dans lequel le substrat est refroidi par la circulation d'un milieu de refroidissement.

3. Procédé selon la revendication 1 ou 2, dans lequel chacune des étapes de chauffage rapide, de formation par décharge luminescente et de refroidissement rapide est exécutée dans une seule et même chambre à vide.

4. Procédé selon l'une quelconque des revendications précédentes, comprenant en outre une étape de maintien de la température du substrat pendant l'exécution de l'étape de formation par décharge luminescente.

5. Procédé selon l'une quelconque des revendications précédentes, dans lequel, dans l'étape de fourniture du substrat, le film de semi-conducteur de conductivité de type p ou de type n est formé par un procédé de dépôt chimique en phase vapeur CVD activé au plasma.

6. Procédé selon la revendication 5, dans lequel le procédé CVD activé au plasma est un procédé CVD activé au plasma haute fréquence.

7. Procédé selon l'une quelconque des revendications précédentes, dans lequel la décharge luminescente est engendrée par un procédé CVD activé au plasma hyperfréquence.

8. Procédé selon l'une quelconque des revendications précédentes, dans lequel le substrat a une forme analogue à une bande et le substrat est déplacé en continu dans la direction longitudinale pendant l'exécution du procédé.

9. Procédé selon la revendication 8 dépendante de la revendication 3, dans lequel le substrat se déplaçant en continu est chauffé rapidement comme précité, immédiatement avant une entrée de la région de décharge luminescente dans ladite chambre à vide, et le substrat se déplaçant en continu est refroidi rapidement comme précité, immédiatement après une sortie de ladite région de décharge luminescente.
